# EUROPEAN PATENT APPLICATION

(11) **EP 4 498 598 A1**
(43) Date of publication of application: **29.01.2025**
(21) Application number: 23774999.9
(22) Date of filing: 23.03.2023
(51) Int. Cl.: H02S 20/22, C09J 201/00, E04D 13/18, E04F 13/08, H01L 31/048, H02S 30/00

(54) **INSTALLATION STRUCTURE FOR PHOTOVOLTAIC SHEET**

(30) Priority: 23.03.2022 JP 2022047106; 23.03.2022 JP 2022047110; 24.03.2022 JP 2022048272; 22.09.2022 JP 2022151692
(71) Applicant: SEKISUI CHEMICAL CO., LTD., Osaka-shi Osaka 530-8565 (JP)
(72) Inventor: HAYAKAWA, Akinobu, Osaka-shi, Osaka 530-8565 (JP); YOKOTA, Ibuki, Osaka-shi, Osaka 530-8565 (JP); AOKI, Takashi, Osaka-shi, Osaka 530-8565 (JP); FUJIMORI, Yuji, Osaka-shi, Osaka 530-8565 (JP)
(74) Representative: Ter Meer Steinmeister & Partner
(86) International application number: PCT/JP2023/011400
(87) International publication number: WO 2023/182405

(57) **Abstract**

Provided is an installation structure for a photovoltaic power generation sheet that suppresses vibration of the photovoltaic power generation sheet 1 due to wind in a state where the photovoltaic power generation sheet is installed above an installation surface. An installation structure 2 for a photovoltaic power generation sheet 1 of the present disclosure includes an installation surface 3, the photovoltaic power generation sheet 1 installed above the installation surface 3, and a sealing member (bonder 4) that closes a gap between an outer peripheral edge of the photovoltaic power generation sheet 1 and the installation surface 3.

## Description

### Technical Field

The present disclosure relates to an installation structure for a photovoltaic power generation sheet in which a photovoltaic power generation sheet is installed above an installation surface.

### Background Art

Conventionally, a rigid solar cell using silicon for a power generation cell has been used (PTL 1). When this type of solar cell is installed, an installation angle of a solar cell with respect to sunlight is determined by installing an attachment base on an installation surface such as a roof and attaching the solar cell on the attachment base using rivets or the like.

In recent years, flexible solar cells such as perovskite photovoltaic power generation sheets have become widespread. A photovoltaic power generation sheet of this type can adjust an installation angle with respect to sunlight by its own flexibility and is lightweight at the same time, and thus it is expected that the photovoltaic power generation sheet is directly installed on an installation surface without using an attachment base.

### Citation List

### Patent Literature

PTL 1: JPH 07-18797A

### Summary of Invention

### Technical Problem

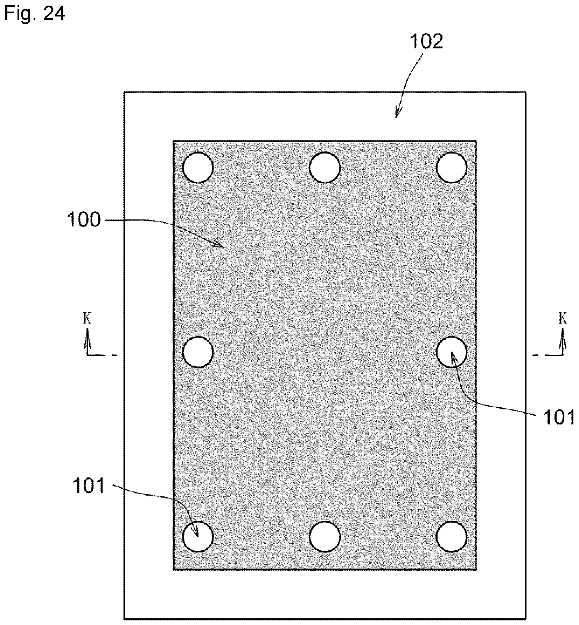

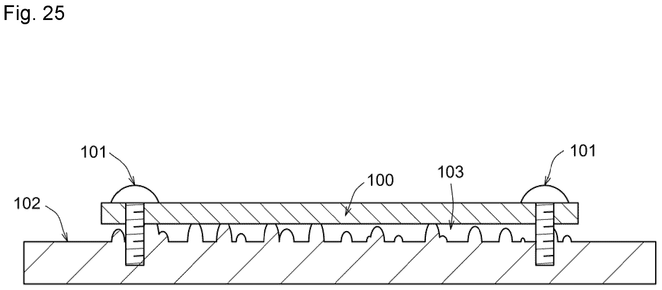

As illustrated in Figs. 24 and 25, in a case where a photovoltaic power generation sheet 100 is fixed to an installation surface 102 using a rivet 101, when there is unevenness on the installation surface 102, a gap 103 is generated between the photovoltaic power generation sheet 100 and the installation surface 102. When wind enters between the photovoltaic power generation sheet 100 and the installation surface 102 from the gap 103, the photovoltaic power generation sheet 100 vibrates and the incident angle of sunlight on the photovoltaic power generation sheet 100 becomes unstable, and therefore the power generation efficiency of the photovoltaic power generation sheet is reduced.

When the conventional rigid solar cell is increased in size by increasing the area or the like, the efficiency of construction work and the efficiency of the transportation industry decrease due to a significant increase in weight. On the other hand, since the photovoltaic power generation sheet is lightweight and does not cause a problem of a case where a rigid solar cell is increased in size, an increase in size has been studied. However, in a case where the size of the photovoltaic power generation sheet is increased, the above-described vibration due to the influence of wind becomes large, and the problem of the decrease in power generation efficiency due to the vibration becomes remarkable. This problem is unique to the photovoltaic power generation sheet.

The present disclosure has been made in view of the above matters, and an object of the present disclosure is to provide an installation structure for a photovoltaic power generation sheet that can suppresses vibration of the photovoltaic power generation sheet due to wind in a state where the photovoltaic power generation sheet is installed above an installation surface.

### Solution to Problem

In order to achieve the above object, the present disclosure includes, as a subject, an installation structure for a photovoltaic power generation sheet according to the following item 1.

Item 1. An installation structure for a photovoltaic power generation sheet, including:
an installation surface;
a photovoltaic power generation sheet installed above the installation surface; and
a sealing member that closes a gap between an outer peripheral edge of the photovoltaic power generation sheet and the installation surface.

The present disclosure includes the installation structure for the photovoltaic power generation sheet according to the following item 2 as a preferable aspect of the installation structure for the photovoltaic power generation sheet according to the above item 1.

Item 2. The installation structure to item 1, wherein the sealing member is formed of a bonder provided between at least an outer peripheral portion of the photovoltaic power generation sheet and the installation surface to bond the outer peripheral portion to the installation surface.

The present disclosure includes the installation structure for the photovoltaic power generation sheet according to the following item 3 as a preferable aspect of the installation structure for the photovoltaic power generation sheet according to the above item 2.

Item 3. The installation structure according to item 2, wherein the bonder has a loss factor of 0.01 or more and 0.3 or less.

The present disclosure includes the installation structure for the photovoltaic power generation sheet according to the following item 4 as a preferable aspect of the installation structure for the photovoltaic power generation sheet according to the above item 3.

Item 4. The installation structure for the installation structure for a photovoltaic power generation sheet according to item 3, wherein the bonder has a thickness of 3 mm or more and 20 mm or less.

The present disclosure includes the installation structure for the photovoltaic power generation sheet according to the following item 5 as a preferable aspect of the installation structure for the photovoltaic power generation sheet according to the above items 2 to 4.

Item 5. The installation structure according to any one of items 2 to 4, wherein the bonder has a modulus of transverse elasticity of 0.1 MPa or more and 100 MPa or less.

The present disclosure includes the installation structure for the photovoltaic power generation sheet according to the following item 6 as a preferable aspect of the installation structure for the photovoltaic power generation sheet according to the above items 2 to 5.

Item 6. The installation structure according to any one of items 2 to 5, wherein the bonder has a viscosity of 800cP or more.

The present disclosure includes the installation structure for the photovoltaic power generation sheet according to the following item 7 as a preferable aspect of the installation structure for the photovoltaic power generation sheet according to the above items 2 to 6.

Item 7. The installation structure according to any one of items 2 to 6, wherein the bonder includes at least one or more resin compositions selected from a vinyl acetate resin, an ethylene vinyl acetate resin, an epoxy resin, a cyanoacrylate resin, an acrylic resin, a chloroprene rubber, styrene, a butadiene rubber, a polyurethane resin, a silicone resin, and a modified silicone resin.

The present disclosure includes the installation structure for the photovoltaic power generation sheet according to the following item 8 as a preferable aspect of the installation structure for the photovoltaic power generation sheet according to the above items 2 to 7.

Item 8. The installation structure according to any one of items 2 to 7, wherein the bonder is provided between the entire photovoltaic power generation sheet and the installation surface.

The present disclosure includes the installation structure for the photovoltaic power generation sheet according to the following item 9 as a preferable aspect of the installation structure for the photovoltaic power generation sheet according to the above items 2 to 8.

Item 9. The installation structure according to any one of items 2 to 8, further including:
a cover member that covers the bonder between an outer peripheral edge of the photovoltaic power generation sheet and the installation surface, wherein
the cover member has an ultraviolet ray blocking property.

The present disclosure includes the installation structure for the photovoltaic power generation sheet according to the following item 10 as a preferable aspect of the installation structure for the photovoltaic power generation sheet according to the above item 9.

Item 10. The installation structure according to item 9, wherein the cover member includes a covered portion that covers a portion having a predetermined width from an outer peripheral edge on a front surface of the photovoltaic power generation sheet.

The present disclosure includes the installation structure for the photovoltaic power generation sheet according to the following item 11 as a preferable aspect of the installation structure for the photovoltaic power generation sheet according to the above item 1.

Item 11. The installation structure according to item 1, wherein the sealing member includes a cover member that covers a gap between an outer peripheral edge of the photovoltaic power generation sheet and the installation surface.

The present disclosure includes the installation structure for the photovoltaic power generation sheet according to the following item 12 as a preferable aspect of the installation structure for the photovoltaic power generation sheet according to the above item 1.

Item 12. The installation structure according to item 1, wherein the sealing member is formed of a joint material filled in a gap between at least an outer peripheral portion of the photovoltaic power generation sheet and the installation surface.

The present disclosure includes the installation structure for the photovoltaic power generation sheet according to the following item 13 as a preferable aspect of the installation structure for the photovoltaic power generation sheet according to the above items 1 to 12.

Item 13. The installation structure according to any one of items 1 to 12, wherein the photovoltaic power generation sheet is flexible.

### Advantageous Effects of Invention

According to the installation structure for the photovoltaic power generation sheet of the present disclosure, it is possible to suppress vibration of the photovoltaic power generation sheet due to wind in a state where the photovoltaic power generation sheet is installed above the installation surface.

### Brief Description of Drawings

Fig. 1 is a schematic plan view illustrating an installation structure for a photovoltaic power generation sheet according to a first embodiment of the present disclosure.
Fig. 2 is a cross-sectional view taken along line A-A of Fig. 1.
Fig. 3(A) is a cross-sectional view of the photovoltaic power generation sheet. Fig. 3(B) is an enlarged view of a part a in Fig. 3(A). Fig. 3(C) is a cross-sectional view illustrating a state in which the power generator is cut along line B-B of Fig. 3(A).
Fig. 4 is a back view illustrating a modification of the photovoltaic power generation sheet.
Fig. 5 is a back view illustrating a modification of the photovoltaic power generation sheet.
Fig. 6 is a back view illustrating a modification of the photovoltaic power generation sheet.
Fig. 7 is a back view illustrating a modification of the photovoltaic power generation sheet.
Fig. 8 is a schematic plan view illustrating an installation structure for a photovoltaic power generation sheet according to a second embodiment of the present disclosure.
Fig. 9 is a cross-sectional view taken along line C-C in Fig. 8.
Fig. 10 is a schematic plan view illustrating an installation structure for a photovoltaic power generation sheet according to a third embodiment of the present disclosure.
Fig. 11 is a cross-sectional view taken along line D-D in Fig. 10.
Fig. 12 is a schematic plan view illustrating an installation structure for a photovoltaic power generation sheet according to a modification of the third embodiment of the present disclosure.
Fig. 13 is a cross-sectional view taken along line E-E in Fig. 12.
Figs. 14(A) and 14(B) are schematic cross-sectional views of a covered portion of a cover member.
Fig. 15 is a schematic plan view illustrating a modification of the installation structure for the photovoltaic power generation sheet according to the third embodiment of the present disclosure.
Fig. 16 is a back view illustrating a modification of the photovoltaic power generation sheet.
Figs. 17(A) to 17(D) are cross-sectional views for describing a procedure of peeling off the photovoltaic power generation sheet from the installation surface.
Fig. 18(A) is a schematic plan view illustrating an installation structure for a photovoltaic power generation sheet according to another embodiment of the present disclosure, Fig. 18(B) is a cross-sectional view taken along line F-F in Fig. 18(A), and Fig. 18(C) is a cross-sectional view taken along line G-G in Fig. 18(A).
Fig. 19(A) is a schematic plan view illustrating an installation structure for a photovoltaic power generation sheet according to another embodiment of the present disclosure, Fig. 19(B) is a cross-sectional view taken along line H-H of Fig. 19(A), and Fig. 19(C) is a cross-sectional view taken along line I-I of Fig. 19(A).
Fig. 20 is a schematic perspective view of an installation structure for a photovoltaic power generation sheet according to another embodiment of the present disclosure.
Fig. 21 is a plan view of Fig. 20.
Fig. 22(A) is a schematic plan view of a spacer member, Fig. 22(B) is a schematic front view of the spacer member, and Fig. 22(C) is a cross-sectional view taken along line J-J in Fig. 22(A).
Fig. 23 is a schematic plan view illustrating that the spacer member is movable with respect to the photovoltaic power generation sheet.
Fig. 24 is a schematic plan view illustrating an installation structure for a conventional photovoltaic power generation sheet.
Fig. 25 is a schematic cross-sectional view taken along line E-E in Fig. 10.

### Description of Embodiments

Hereinafter, embodiments of the present disclosure will be described with reference to the accompanying drawings.

### First embodiment

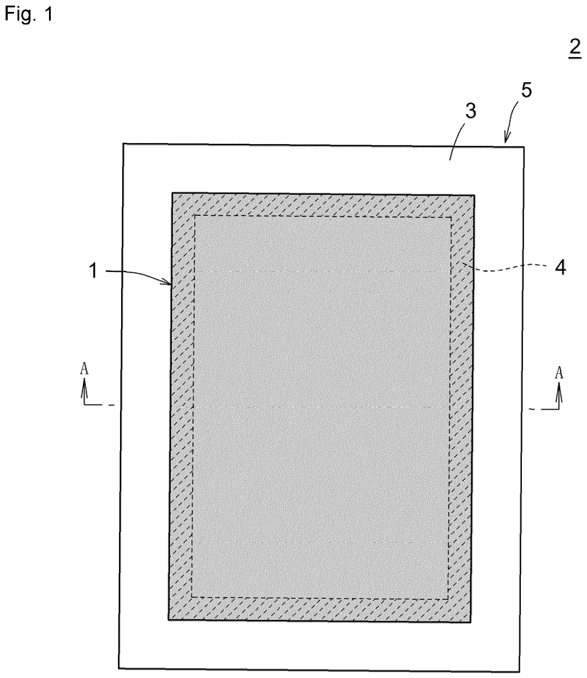

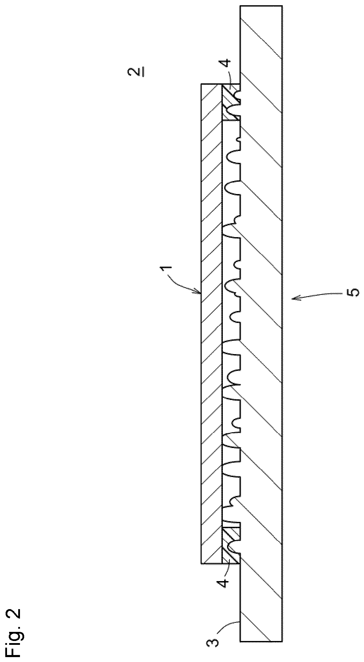

Figs. 1 and 2 illustrate an installation structure 2 for a photovoltaic power generation sheet according to a first embodiment of the present disclosure.

The installation structure 2 according to the first embodiment includes an installation surface 3, a photovoltaic power generation sheet 1 installed above the installation surface 3, and a bonder 4 for fixing the photovoltaic power generation sheet 1 to the installation surface 3. The bonder 4 also functions as a sealing member for closing a gap between the outer peripheral edge of the photovoltaic power generation sheet 1 and the installation surface 3. As a result, it is possible to suppress wind from entering between the photovoltaic power generation sheet 1 and the installation surface 3, and it is possible to suppress vibration of the photovoltaic power generation sheet 1 the due to the influence of the wind. Therefore, the power generation efficiency of the photovoltaic power generation sheet 1 can be stably maintained.

Hereinafter, each component of the installation structure 20 according to the first embodiment will be described.

### Installation surface 3

The installation surface 3 is a surface of the installation object of the photovoltaic power generation sheet 1, and is configured by, for example, a surface of the building material 5. Examples of the building material 5 include a roof material, a wall material (metal-based siding material, ceramic-based siding material, sandwich panel, and the like), a partition, a door material, a fence material, and a floor material. Examples of the roof member include roof members used for a folded plate roof, a slate roof, a roof deck, a shingled bar-laid roof, an upright flat laid roof, and the like. The roof may be a vertical roof or a horizontal roof. The building material 5 may be used for a non-residential building or may be used for a residential building. The non-residential building is not particularly limited, and examples thereof include a store, a warehouse, a factory, a vinyl house, a greenhouse, a meeting place, a gymnasium, and a parking lot. Note that the installation surface 3 may be constituted by a surface of another structure, for example, a surface of a road, a ground, an embankment, or the like, or may be constituted by a surface of an automobile, a train, a ship, or the like. The installation surface 3 is formed of, for example, metal, resin, asphalt, concrete, or the like. The installation surface 3 may be a surface on which, for example, soil, sand, gravel, or the like is deposited.

Further, the installation surface 3 may include a surface of a sheet member such as a resin sheet laid and fixed on the surface of the structure described above.

The installation surface 3 may be a horizontal plane perpendicular to the direction in which gravity acts, or may be a plane intersecting the horizontal plane at an angle. The installation surface 3 intersecting the horizontal plane at an angle includes an inclined surface forming a predetermined inclination angle θ (0° < θ < 90°) with respect to the horizontal plane and a vertical plane perpendicular to the horizontal plane. In the present embodiment, the installation surface 3 is a horizontal plane. The installation surface 3 may be a flat surface or a curved surface, and its surface state may be smooth or uneven such as rough. In addition, the installation surface 3 may be a corrugated surface in which a plurality of crest portions and a plurality of valley portions are bent in such a manner of being alternately arranged.

The upper limit of the arithmetic average roughness measured in JIS B0601 of the installation surface 3 is preferably 5 mm or less, more preferably 1 mm or less, and more preferably 0.5 mm or less, and the lower limit of the arithmetic average roughness measured in JIS B0601 of the installation surface 3 is 0.1 µm or more, more preferably 10 µm or more, and more preferably 100 µm or more. As long as the surface roughness of the installation surface 3 is in the above range, it is possible to suppress wind from blowing from the outer peripheral edge of the photovoltaic power generation sheet 1 to between the photovoltaic power generation sheet 1 and the installation surface 3. In addition, the bonding force of a bonder 4 is increased by the anchor effect caused by the bonder 4 entering the unevenness of the installation surface 3, and the fixing force of the photovoltaic power generation sheet 1 to the installation surface 3 can be increased.

### Photovoltaic power generation sheet 1

The photovoltaic power generation sheet 1 is formed in a sheet shape, and generates power when at least one surface (for example, a front surface) in a thickness direction receives sunlight. The term "sheet shape" as used herein refers to a shape in which the thickness of the object is 10% or less with respect to the maximum length between the outer edges in plan view. When the shape in plan view is a rectangular shape, the "maximum length between the outer edges in plan view" refers to a length of a diagonal line. When the shape in plan view is a circular shape, the "maximum length between the outer edges in plan view" refers to the length of the diameter. In the present description, a film shape, a foil shape, a film shape, and the like are also included in the "sheet shape".

The photovoltaic power generation sheet 1 is formed in a substantially rectangular shape in plan view. The shape of the photovoltaic power generation sheet 1 is not limited to a substantially rectangular shape in plan view, and may be, for example, a substantially circular shape in plan view, an elliptical shape in plan view, a polygonal shape in plan view, or the like.

The photovoltaic power generation sheet 1 is flexible. The lower limit of the flexural strength of the photovoltaic power generation sheet 1 is preferably 10 MPa or more, more preferably 50 MPa or more, and more preferably 100 MPa or more, and the upper limit of the flexural strength of the photovoltaic power generation sheet 1 is preferably 200 MPa or less, more preferably 150 MPa or less, and more preferably 130 MPa or less. Further, the flexibility of the photovoltaic power generation sheet 1 may be defined by a flexural modulus. The lower limit of the flexural modulus of the photovoltaic power generation sheet 1 is preferably 100 MPa or more, more preferably 500 MPa or more, and the upper limit of the flexural modulus of the photovoltaic power generation sheet 1 is preferably 10,000 MPa or less, more preferably 5000 MPa or less. When the photovoltaic power generation sheet 1 is defined by the flexural modulus, the flexural strength may not be included in the above range. Since the flexural strength or the flexural modulus of the photovoltaic power generation sheet 1 is set within the above range, it is possible to suppress occurrence of breakage such as cracking while making construction favorably. The flexural strength and the flexural modulus of the photovoltaic power generation sheet 1 are measured by, for example, a measurement method in accordance with JIS K7171.

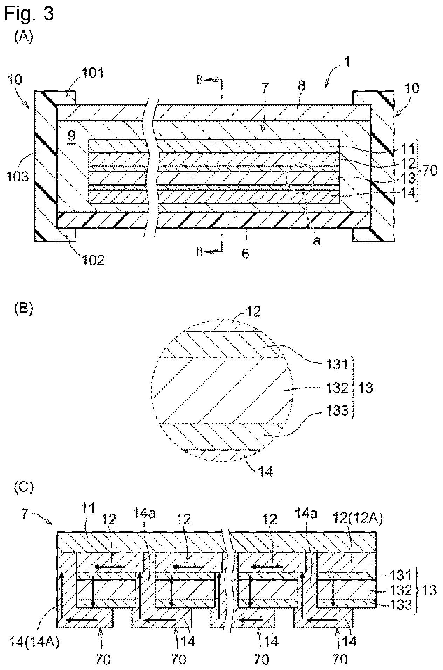

As illustrated in Fig. 3(A), the photovoltaic power generation sheet 1 includes a back sheet 6, a power generator 7, a barrier sheet 8, a sealant 9, and a sealing edge member 10. The power generator 7 and the sealant 9 are disposed between the back sheet 6 and the barrier sheet 8. The sealing edge member 10 seals between the outer peripheral edge of the back sheet 6 and the outer peripheral edge of the barrier sheet 8.

### Back sheet 6

The back sheet 6 is disposed on a side opposite to the light receiving surface of the photovoltaic power generation sheet 1. The back sheet 6 constitutes a surface of the photovoltaic power generation sheet 1 facing the installation surface 3 (Figs. 1 and 2). The back sheet 6 has barrier performance against water vapor and protection performance against external force. The back sheet 6 may be translucent, and does not necessarily need to be translucent.

The term "be translucent" as used herein refers to a light transmittance of 10% or more with respect to the peak wavelength of light prior to incidence.

The back sheet 6 is flexible. The lower limit of the modulus of longitudinal elasticity of the back sheet 6 is preferably 100 MPa or more, more preferably 1000 MPa or more, more preferably 2400 MPa or more, and more preferably 3000 MPa or more, and the upper limit of the modulus of longitudinal elasticity of the back sheet 6 is preferably 10,000 MPa or less, more preferably 5000 MPa or less, more preferably 4200 MPa or less, and more preferably 4000 MPa or less. Examples of the material of the back sheet 6 include a plastic film, a plastic substrate, and the like made of a synthetic resin such as a thermoplastic resin, a thermosetting resin, a general-purpose plastic, an engineering plastic, and a vinyl resin (for example, polyvinyl chloride). As a material of the back sheet 11, for example, natural resin, rubber, metal, carbon, pulp, or the like may be used in addition to the synthetic resin.

The lower limit of the thickness of the back sheet 6 is preferably 50 µm or more, more preferably 100 µm or more, and more preferably 200 µm or more, and the upper limit of the thickness of the back sheet 6 is preferably 2000 µm, more preferably 1000 µm or less, more preferably 800 µm or less, and more preferably 600 µm or less. When the thickness of the back sheet 6 is in the above range, the flexural strength of the photovoltaic power generation sheet 1 can be easily set in the above range.

### Power generator 7

The power generator 7 includes a power generation cell 70 which is a photoelectric conversion element using a photovoltaic effect. In the present embodiment, the power generator 7 includes a photoelectric conversion unit in which a plurality of power generation cells 70 are arranged in a surface direction of the photovoltaic power generation sheet 1 (for example, a longitudinal direction and/or a width direction of the photovoltaic power generation sheet 1). Note that the power generator 7 may be configured by one power generation cell 70.

As illustrated in Fig. 3(A), the power generation cell 70 includes a translucent base member 11, a translucent conductive layer 12, a power generation layer 13, and an electrode 14. The translucent base member 11, the translucent conductive layer 12, the power generation layer 13, and the electrode 14 are stacked in this order in a direction from the barrier sheet 8 toward the back sheet 6. That is, the translucent base member 11 is disposed in a manner of facing the barrier sheet 8, and the electrode 14 is disposed in a manner of facing the back sheet 6.

### Translucent base member 11

The translucent base member 11 supports the translucent conductive layer 12, the power generation layer 13, and the electrode 14. The translucent base member 11 is translucent. For the translucency of the translucent base member 11, the light transmittance is 10% or more with respect to the peak wavelength of light prior to incidence., and is preferably 50% or more, more preferably 80% or more. In the present description, "transparent" is defined as having a light transmittance of 80% or more with respect to the peak wavelength of light prior to incidence.

Examples of the material of the translucent base member 11 include an inorganic material, an organic material, and a metal material. Examples of the inorganic material include quartz glass and alkali-free glass. Examples of the organic material include polyethylene terephthalate (PET), polyethylene naphthalene (PEN), polyethylene, polyimide, polyamide, polyamideimide, liquid crystal polymers, cyclo-olefin polymers, and other plastics and polymer films. Examples of the metal material include stainless steel, aluminum, titanium, and silicon.

The thickness of the translucent base member 11 is not particularly limited as long as the translucent base member 11 can support the translucent conductive layer 12, the power generation layer 13, and the electrode 14, and the thickness of the translucent base member 11 is, for example, 30 µm or more and 300 µm or less.

The translucent base member 11 is a base member required in the manufacturing process of the power generation cell 70. The translucent base member 11 is not necessarily required, and for example, may be used only during the manufacturing of the photovoltaic power generation sheet 1, or may be removed after or during the manufacturing. When removed, a base member that is not translucent may be used instead of the translucent base member 11.

### Translucent conductive layer 12

The translucent conductive layer 12 is a layer that is conductive and functions as a cathode. The translucent conductive layer 12 is translucent. The translucent conductive layer 12 is preferably transparent.

Examples of the translucent conductive layer 12 include indium tin oxide (ITO), fluorine-doped tin oxide (FTO), nesa films, and other transparent materials. The translucent conductive layer 12 is formed on the surface of a translucent substrate by, for example, a sputtering method, an ion plating method, a plating method, a coating method, or the like.

In addition, the translucent conductive layer 12 may be configured to be translucent by forming a pattern capable of transmitting light while using a material that is not translucent. Examples of the material that is not translucent include platinum, gold, silver, copper, aluminum, rhodium, indium, titanium, nickel, tin, zinc, and alloys containing these metals. Examples of the pattern capable of transmitting light include a lattice shape, a linear shape, a wavy line shape, a honeycomb shape, and a round hole shape.

The thickness of the translucent conductive layer 12 is preferably, for example, 30 nm or more and 300 nm or less. When the thickness of the translucent conductive layer 12 is 30 nm or more and 300 nm or less, excellent conductivity can be obtained while maintaining high flexibility.

### Power generation layer 13

The power generation layer 13 is a layer that causes photoelectric conversion by light irradiation, producing electrons and holes from excitons generated by light absorption. As illustrated in Fig. 3(B), the power generation layer 13 includes a hole transport layer 131, a photoelectric conversion layer 132, and an electron transport layer 133. The hole transport layer 131, the photoelectric conversion layer 132, and the electron transport layer 133 are stacked in this order in a direction from the translucent conductive layer 12 toward the electrode 14.

### Hole transport layer 131

The hole transport layer 131 extracts holes generated in the photoelectric conversion layer 132 to the translucent conductive layer 12, and prevents electrons generated in the photoelectric conversion layer 132 from moving to the translucent conductive layer 12. As a material of the hole transport layer 131, for example, a metal oxide can be used. Examples of the metal oxide include titanium oxide, molybdenum oxide, vanadium oxide, zinc oxide, nickel oxide, lithium oxide, calcium oxide, cesium oxide, and aluminum oxide. In addition, a delafosite-type compound semiconductor (CuGaO₂), copper oxide, copper thiocyanate (CuSCN), vanadium pentoxide (V₂O₅), graphene oxide, or the like may be used. Furthermore, as a material of the hole transport layer 131, a p-type organic semiconductor or a p-type inorganic semiconductor can also be used.

The lower limit of the thickness of the hole transport layer 131 is preferably 1 nm or more and more preferably 10 nm or more, and the upper limit of the thickness of the hole transport layer 131 is preferably 1000 nm or less, more preferably 500 nm or less, and more preferably 50 nm or less. As long as the thickness of the hole transport layer 131 is in the above range, hole transport can be realized.

### Photoelectric conversion layer 132

The photoelectric conversion layer 132 (photoactive layer) is a layer that photoelectrically converts absorbed light. The material of the photoelectric conversion layer 132 is not particularly limited as long as the photoelectric conversion layer 132 can photoelectrically convert absorbed light, and for example, amorphous silicon, perovskite, a non-silicon-based material (semiconductor material CIGS), or the like is used. In addition, the photoelectric conversion layer 132 may have a tandem stacked structure that composites these materials. For the photoelectric conversion layer 132 using a non-silicon-based material, a semiconductor material CIGS containing copper (Cu), indium (In), gallium (Ga), and selenium (Se) is used, and the thickness of the photoelectric conversion layer is easily reduced.

Hereinafter, as an example of the photoelectric conversion layer 132, a photoelectric conversion layer using perovskite will be described. The photoelectric conversion layer 132 containing a perovskite compound has an advantage that dependence of power generation efficiency on an angle of incident light (hereinafter, there may be referred to as dependence on the incident angle) is relatively low. As a result, since the photovoltaic power generation sheet 1 has less dependency on the gradient of the installation surface 3, the photovoltaic power generation sheet 1 can be installed in a broader location as compared with that in other solar cells, and higher power generation efficiency can be obtained.

The perovskite compound is a structure having a perovskite crystal structure and a crystal similar thereto. The perovskite crystal structure is represented by the composition formula ABX₃. In this composition formula, for example, A represents an organic cation, B represents a metal cation, and X represents a halogen anion. Here, the A site, the B site, and the X site are not limited thereto.

The organic group of the organic cation of the A site is not particularly limited, and examples thereof include alkylammonium derivatives and formamidinium derivatives. The organic cation of the A site may be one kind or two or more kinds.

The metal of the metal cation of the B site is not particularly limited, and examples thereof include Cu, Ni, Mn, Fe, Co, Pd, Ge, Sn, Pb, and Eu. The metal cation of the B site may be one kind or two or more kinds.

The halogen of the halogen anion of the X site is not particularly limited, and examples thereof include F, Cl, Br, and I. The halogen anion of the X site may be one kind or two or more kinds.

The lower limit of the thickness of the photoelectric conversion layer 132 is preferably 1 nm or more, more preferably 5 nm or more, more preferably 10 nm or more, more preferably 100 nm or more, and more preferably 300 nm or more, and the upper limit of the thickness of the photoelectric conversion layer 132 is preferably 1 million nm or less, more preferably 50,000 nm or less, and more preferably 1000 nm or less. As long as the thickness of the photoelectric conversion layer 132 is in the above range, the photoelectric conversion efficiency is improved.

### Electron transport layer 133

The electron transport layer 133 extracts electrons generated in the photoelectric conversion layer 132 to the electrode 14, and prevents holes generated in the photoelectric conversion layer 132 from moving to the electrode 14. The electron transport layer 133 preferably contains, for example, either a halogen compound or a metal oxide.

Examples of the halogen compound include lithium halide (LiF, LiCl, LiBr, LiI) and sodium halide (NaF, NaCl, NaBr, NaI). Examples of the element of the metal oxide include titanium, molybdenum, vanadium, zinc, nickel, lithium, potassium, cesium, aluminum, niobium, tin, and barium. As a material of the electron transport layer 133, an n-type organic semiconductor or an n-type inorganic semiconductor can also be used.

The lower limit of the thickness of the electron transport layer 133 is preferably 1 nm or more and more preferably 10 nm or more, and the upper limit of the thickness of the electron transport layer 133 is preferably 1000 nm or less, more preferably 500 nm or less, and more preferably 50 nm or less. As long as the thickness of the electron transport layer 133 is in the above range, electron transport can be realized.

### Electrode 14

The electrode 14 is conductive and functions as an anode. The electrode 14 can extract electrons from the photoelectric conversion layer 132 according to photoelectric conversion generated by the photoelectric conversion layer 132. The electrode 14 may be translucent or may be made of a material that is not translucent. Examples of the material of the electrode 14 include platinum, gold, silver, copper, aluminum, rhodium, indium, titanium, nickel, tin, zinc, and alloys containing these metals.

### Barrier sheet 8

The barrier sheet 8 is disposed on a side opposite to the back sheet 6 in the thickness direction of the photovoltaic power generation sheet 1. The barrier sheet 8 includes a light receiving surface of the photovoltaic power generation sheet 1. The barrier sheet 8 is translucent. The barrier sheet 8 is preferably transparent. The barrier sheet 8 has barrier performance against water vapor and protection performance against external force.

The barrier sheet 8 is flexible. The lower limit of the modulus of longitudinal elasticity of the barrier sheet 8 is preferably 100 Pa or more, more preferably 1000 MPa or more, more preferably 2400 MPa or more, and more preferably 3000 MPa or more, and the upper limit of the modulus of longitudinal elasticity of the barrier sheet 8 is preferably 10,000 MPa or less, more preferably 5000 MPa or less, more preferably 4200 MPa or less, and more preferably 4000 MPa or less. Examples of the material of the barrier sheet 8 include a plastic film and a vinyl film made of a synthetic resin such as a thermoplastic resin, a thermosetting resin, a general-purpose plastic, an engineering plastic, and a vinyl resin (for example, polyvinyl chloride). As a material of the barrier sheet 17, for example, a natural resin, rubber, metal, pulp, or the like may be used in addition to a synthetic resin.

The lower limit of the thickness of the barrier sheet 8 is preferably 50 µm or more, more preferably 100 µm or more, and more preferably 200 µm or more, and the upper limit of the thickness of the barrier sheet 8 is preferably 2000 µm or less, more preferably 1000 µm or less, more preferably 800 µm or less, and more preferably 600 µm or less. When the thickness of the barrier sheet 8 is in the above range, the flexural strength of the photovoltaic power generation sheet 1 can be easily set in the above range.

### Sealant 9

The sealant 9 is filled between the barrier sheet 8 and the back sheet 6 in a state where the power generation layer 13 is disposed between the barrier sheet 8 and the back sheet 6. The sealant 9 prevents water from entering the power generation layer 13 from around the power generation layer 13. The sealant 9 is translucent and is preferably transparent.

Examples of the material of the sealant 9 include ethylene vinyl acetate (EVA), polyolefin, butyl rubber, silicone resin, polyvinyl butyral, acrylic resin, polyisobutylene resin, SBS resin, SIBS resin, epoxy resin, and the like.

### Sealing edge member 10

The sealing edge member 10 seals the entire circumference between the outer peripheral edge of the back sheet 6 and the outer peripheral edge of the barrier sheet 8 in a state where a plurality of power generation cells 70 and the sealant 9 are disposed between the back sheet 6 and the barrier sheet 8. The outer peripheral edge of the sealing edge member 10 constitutes the outer peripheral edge of the photovoltaic power generation sheet 1. As illustrated in Fig. 3(A), the sealing edge member 10 includes a first bonding portion 101, a second bonding portion 102, and a sealing portion 103 connecting the first bonding portion 101 and the second bonding portion 102. The first bonding portion 101 is bonded to a front surface (upper surface in the drawing) of the barrier sheet 8. The second bonding portion 102 is bonded to a back surface (lower surface in the drawing) of the back sheet 6. The first bonding portion 101, the sealing portion 103, and the second bonding portion 102 are integrally formed.

Examples of the material of the sealing edge member 10 include a tape material made of butyl rubber, silicone rubber, or the like.

### Action of photovoltaic power generation sheet 1

When the photovoltaic power generation sheet 1 is irradiated with light from the front surface side (barrier sheet 8 side) of the photovoltaic power generation sheet 1, the photoelectric conversion layer 132 of the power generation layer 13 absorbs light and performs photoelectric conversion, so that electrons and holes are generated in the photoelectric conversion layer 132. When the electrons are extracted to the electrode 14 (anode) via the electron transport layer 133 and holes are extracted to the translucent conductive layer 12 (cathode) via the hole transport layer 131, a current flows from the translucent conductive layer 12 to the electrode 14 (that is, power generation is performed).

In the photoelectric conversion unit of the power generator 7, an extension portion 14a is provided in the electrode 14 (anode) of each power generation cell 70 (Fig. 3(C)). The extension portion 14a of the electrode 14 extends toward the translucent conductive layer 12 (cathode) side. In two adjacent power generation cells 70, 70, the extension portion 14 of the electrode 14 of one cell 70 is joined to the translucent conductive layer 12 of the other cell 70. By this joining, while the photovoltaic power generation sheet 1 is irradiated with light, a current flows from the translucent conductive layer 12A at one side end of the power generator 7 (photoelectric conversion unit) to the electrode 14A at the other side end of the power generator 7 (the flow of the current is indicated by an arrow in Fig. 3(C)). The current is extracted via a power distribution line.

In a case where the power generator 7 is configured by the photoelectric conversion unit described above, when a failure occurs in some of the power generation cells 70, the amount of electricity extracted from the power generator 7 can still be stabilized.

Instead of providing the extension portion 14a on the electrode 14 (anode) of each power generation cell 70, an extension portion extending toward the electrode 14 (anode) side may be provided on the translucent conductive layer 12 (cathode) of each power generation cell 70. In this case, in two adjacent power generation cells 70,70, the extension portion of the translucent conductive layer 12 of one cell 70 is joined to the electrode 14 of the other cell 70. In this case, the same effect as described above can still be obtained.

In a case where the translucent base member 11 is provided in the power generator 7, it is preferable to support the translucent conductive layer 12, the power generation layer 13, and the electrode 14 of each power generation cell 70 on the common translucent base member 11 as illustrated in Fig. 3(C) from the viewpoint of facilitating the manufacturing of the power generator 7.

In addition, in a case where the power generator 70 includes one power generation cell 70, the current flowing from the electrode 14 to the translucent conductive layer 12 is extracted via a power distribution line.

The photovoltaic power generation sheet 1 may include a plurality of power generators 70. In this case, the plurality of power generators 70 are arranged in the surface direction of the photovoltaic power generation sheet 1 and are electrically connected in series or in parallel.

In a case where the power generator 7 includes a photoelectric conversion unit, in order to connect the plurality of power generators 70 in series, for two adjacent power generators 7, 7, the translucent conductive layer 12A at the end of one power generator 7 and the electrode 14A at the end of the other power generator 7 are connected via a power distribution line. In a case where the plurality of power generators 70 are connected in parallel, the translucent conductive layers 12A, 12A at the ends of two adjacent power generators 7, 7 and the electrodes 14A, 14A at the ends of the two adjacent power generators 7, 7 are connected via a power distribution line, respectively.

In addition, in a case where the power generator 7 includes one power generation cell 70, in order to connect the plurality of power generators 7 in series, for two adjacent power generators 7, 7, the translucent conductive layer 12 of one power generator 7 and the electrode 14 of the other power generator 7 are connected via a power distribution line. In a case where the plurality of power generators 7 are connected in parallel, the translucent conductive layers 12, 12 of two adjacent power generators 7, 7 and the electrodes 14, 14 of the two adjacent power generators 7, 7 are connected via a power distribution line, respectively.

Note that in a case where the power generator 7 includes any one of the photoelectric conversion unit and one power generation cell 70, the distance between adjacent power generators 7, 7 may be more than 0 mm, preferably 2 mm or more, more preferably 10 mm or more, and still more preferably 15 mm or more. The distance between adjacent power generators 7, 7 is preferably 100 mm or less, more preferably 50 mm or more, and still more preferably 20 mm or less.

### Bonder 4

As illustrated in Figs. 1 and 2, the bonder 4 is provided between at least the outer peripheral portion of the photovoltaic power generation sheet 1 and the installation surface 3. The photovoltaic power generation sheet 1 is fixed to the installation surface 3 by bonding at least the outer peripheral portion to the installation surface 3 with the bonder 4. In the present specification, the "outer peripheral portion of the photovoltaic power generation sheet" refers to an annular range of the photovoltaic power generation sheet 1 having a predetermined width from the outer peripheral edge of the photovoltaic power generation sheet 1.

The lower limit of the viscosity of the bonder 4 is preferably 800cP or more, and more preferably 1000cP or more. When the viscosity of the bonder 4 is in the above range, the photovoltaic power generation sheet 1 can be strongly adhered to the installation surface 3. The viscosity of the bonder 4 may be less than 800cP, and is preferably 100cP or more. The upper limit of the viscosity of the bonder 4 is preferably 10×10⁷cP or less, more preferably 10×10⁶cP or less, and still more preferably 10×10⁴cP or less from the viewpoint of handleability of the bonder 4.

The lower limit of the loss factor (tanδ) of the bonder 4 with respect to vibration is preferably 0.01 or more, more preferably 0.05 or more, and more preferably 0.07 or more, and the upper limit of the loss factor (tanδ) of the bonder 4 with respect to vibration is preferably 0.3 or less, more preferably 0.25 or less, and more preferably 0.2 or less. The loss factor indicates the amount of vibration energy transmitted from the installation surface 3 to the photovoltaic power generation sheet 1 via the bonder 4. The loss factor is calculated by the storage modulus/loss modulus of the bonder 4. The loss factor can be measured according to JIS K7244-10 using a rheometer.

When the photovoltaic power generation sheet 1 is installed on the installation surface 3 such as a roof or a wall, the photovoltaic power generation sheet 1 may vibrate along with the vibration of the installation surface 3 in addition to the influence of wind. Even when the photovoltaic power generation sheet 1 vibrates due to the vibration of the installation surface 3, the power generation efficiency of the photovoltaic power generation sheet 1 may be reduced. In particular, when the size of the photovoltaic power generation sheet 1 is increased, the vibration of the photovoltaic power generation sheet 1 caused by the vibration of the installation surface 3 described above increases, and the photovoltaic power generation sheet 1 has a significant problem of a decrease in power generation efficiency due to the vibration.

When the loss factor of the bonder 4 is in the above range, the vibration of the installation surface 3 can be effectively consumed in the cured layer of the bonder 4 as an elastic loss of energy, so that the photovoltaic power generation sheet 1 can be suppressed from vibrating. In addition, the photovoltaic power generation sheet 1 can be strongly fixed to the installation surface 3 by the bonder 4, and particularly even when the installation surface 3 is inclined and the installation angle of the photovoltaic power generation sheet 1 approaches vertical to the horizontal plane, it is possible to suppress the photovoltaic power generation sheet 1 from sliding down the installation surface 3.

The lower limit of the thickness of the bonder 4 is preferably 0.1 mm or more, more preferably 1 mm or more, and more preferably 3 mm or more, and the upper limit of the thickness of the bonder 4 is preferably 20 mm or less, more preferably 15 mm or less, and more preferably 10 mm or less. When the thickness of the bonder 4 is in the above range, the vibration of the installation surface 3 can be effectively suppressed in the cured layer of the bonder 4, and the vibration of the photovoltaic power generation sheet 1 can be suppressed. In addition, the weight load on the installation surface 3 can be reduced.

The lower limit of the modulus of transverse elasticity of the cured layer of the bonder 4 is preferably 0.1 MPa or more, more preferably 0.5 MPa or more, and more preferably 1 MPa or more, and the upper limit of the modulus of transverse elasticity of the cured layer of the bonder 4 is preferably 100 MPa or less, more preferably 50 MPa or less, and more preferably 10 MPa or less. Since the modulus of transverse elasticity of the cured layer of the bonder 4 is in the above range, the photovoltaic power generation sheet 1 can be constructed along the installation surface 3 according to the shape of the installation surface 3, so that the area can be effectively utilized.

The peel strength of the photovoltaic power generation sheet 1 to the installation surface 3 via the bonder 4 is preferably 0.1 N/cm or more. The peel strength is a measurement result obtained in a 90° peel test in accordance with JIS K6854-1, and in a case where the peel strength deteriorates over time, the peel strength is defined as the peel strength at the time of construction.

As the bonder 4, for example, a resin composition containing at least one or more selected from a vinyl acetate resin, ethylene-acetic acid, a vinyl resin, an epoxy resin, a cyanoacrylate resin, an acrylic resin, a chloroprene rubber, styrene, a butadiene rubber, a polyurethane resin, a silicone resin, and a modified silicone resin can be used. In the present disclosure, the material of the bonder 4 is not limited to the resin composition described above.

The bonder 4 may be applied to the installation surface 3 or the photovoltaic power generation sheet 1 at a construction site, or may be provided in advance in a sheet shape or the like on the photovoltaic power generation sheet 1 or the installation surface 3 (in particular, an installation building material or the like), the bonding surface may be covered with a release protection sheet at the time of transportation to the construction site, and the release protection sheet may be peeled off and used after arrival at the construction site.

In a case where the bonder 4 is provided only between the outer peripheral portion of the photovoltaic power generation sheet 1 and the installation surface 3, the lower limit of the width of the bonder 4 is preferably 5 mm or more, more preferably 100 mm or more, more preferably 150 mm or more, and the upper limit is 250 mm or less, more preferably 200 mm or less, more preferably 175 mm or less as the length in the direction from the outer peripheral edge of the photovoltaic power generation sheet 1 toward the inside along the installation surface 3. When the width of the bonder 4 is in the above range, it is possible to more effectively suppress the vibration of the photovoltaic power generation sheet 1 caused by the influence of wind or the vibration of the installation surface 3 by the bonder 4.

### Operation and effect

According to the installation structure 2 according to the first embodiment, the outer peripheral portion of the photovoltaic power generation sheet 1 is bonded to the installation surface 3 by the bonder 4 in a state where the unevenness of the installation surface 3 on the lower side of the outer peripheral portion of the photovoltaic power generation sheet 1 is filled by the bonder 4. As a result, it is possible to prevent a gap from being generated between the outer peripheral portion of the photovoltaic power generation sheet 1 and the installation surface 3, so that it is possible to suppress wind from entering between the photovoltaic power generation sheet 1 and the installation surface 3. Therefore, since the photovoltaic power generation sheet 1 can be suppressed from vibrating by wind, the installation angle of the photovoltaic power generation sheet 1 with respect to sunlight can be stably maintained. Therefore, the power generation efficiency of the photovoltaic power generation sheet 1 can be stably maintained.

Even when the installation surface 3 vibrates, the vibration of the installation surface can be suppressed in the cured layer of the bonder 4, so that the photovoltaic power generation sheet 1 can be suppressed from vibrating due to the influence of the vibration of the installation surface 3. Therefore, the power generation efficiency of the photovoltaic power generation sheet 1 can be stably maintained.

Further, since the photovoltaic power generation sheet 1 is flexible, the photovoltaic power generation sheet 1 can be bonded to the installation surface 3 by the bonder 4 in a state where the shape and orientation of the photovoltaic power generation sheet 1 are adjusted so that the angle with respect to sunlight at an arbitrary position of the photovoltaic power generation sheet 1 becomes a desired angle.

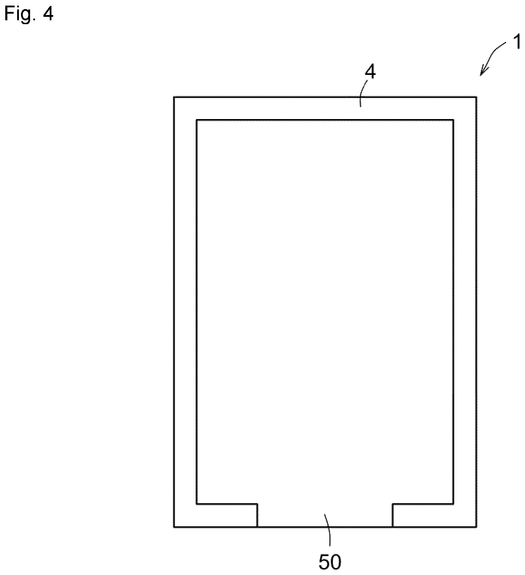

From the viewpoint of suppressing wind from entering between the photovoltaic power generation sheet 1 and the installation surface 3, it is preferable that the bonder 4 is provided between the outer peripheral portion of the photovoltaic power generation sheet 1 and the installation surface 3 over the entire circumference. Here as illustrated in Figs. 4 to 7, the outer peripheral portion of the photovoltaic power generation sheet 1 may include a portion where the bonder 4 is not provided, and the portion may not be bonded to the installation surface 3. In the outer peripheral portion of the photovoltaic power generation sheet 1, a portion where the bonder 4 is not provided is referred to as a non-fixed portion 50.

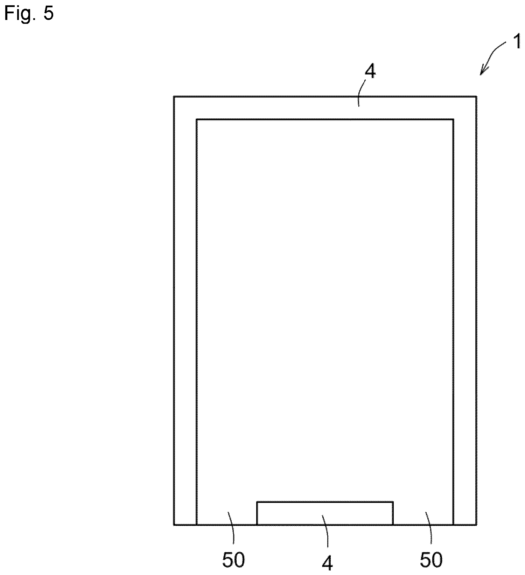

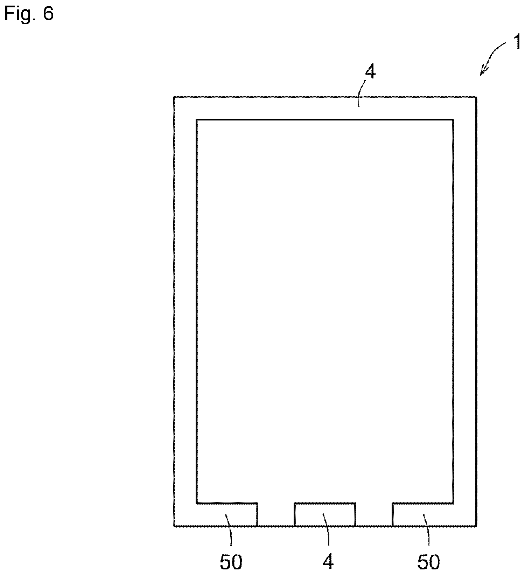

The non-fixed portion 50 is preferably provided at the lower edge portion of the outer peripheral portion of the photovoltaic power generation sheet 1. The lower edge portion is a portion on the lower side of the outer peripheral portion of the photovoltaic power generation sheet 1, and is a portion crossing the downward direction of the inclined installation surface 3. For example, when the shape of the photovoltaic power generation sheet 1 is rectangular in plan view, the non-fixed portion 50 is preferably provided at the outer peripheral portion of the photovoltaic power generation sheet 1, that is, the lower edge portion on the lower side of four linear border portions (upper border portion, left and right border portions, and lower border portion). In this case, as illustrated in Fig. 4, the non-fixed portion 50 may be provided in the central portion of the lower border portion of the photovoltaic power generation sheet 1, as illustrated in Fig. 5, the non-fixed portions 50 may be provided in both side portions of the lower border portion of the photovoltaic power generation sheet 1, or as illustrated in Fig. 6, a plurality of non-fixed portions 50 arranged at equal intervals may be provided in the lower border portion of the photovoltaic power generation sheet 1.

Under a state where the photovoltaic power generation sheet 1 is installed on the installation surface 3, when water such as rainwater enters between the photovoltaic power generation sheet 1 and the installation surface 3, the water flows down the inclined installation surface 3 and flows down to the lower edge portion (lower border portion) of the photovoltaic power generation sheet 1. Then, water is discharged from the opening in the non-fixed portion 50 of the lower edge portion (lower border portion) of the photovoltaic power generation sheet 1. Therefore, it is possible to suppress accumulation of water between the photovoltaic power generation sheet 1 and the installation surface 3, and it is possible to suppress deterioration of the photovoltaic power generation sheet 1 due to contact of water with the power generator 7.

As illustrated in Figs. 5 and 6, it is preferable that the non-fixed portions 50 are provided at corner portions where two side edge portions (two side border portions) of the photovoltaic power generation sheet 1 meet the lower edge portion (lower border portion) of the photovoltaic power generation sheet 1, without the bonder 4 being provided. As a result, water that has entered between the photovoltaic power generation sheet 1 and the installation surface 3 can be discharged without being accumulated in these corner portions.

In the lower edge portion (lower border portion) of the photovoltaic power generation sheet 1, it is preferable that the bonder 4 is not provided at the bottom position and the non-fixed portion 50 is provided. The bottom of the lower edge portion (lower border portion) of the photovoltaic power generation sheet 1 refers to the deepest portion (lowermost portion) in the downward direction of the installation surface 3. When the shape of the photovoltaic power generation sheet 1 is rectangular in plan view, the entire lower edge portion (lower border portion) is the bottom. When the shape of the photovoltaic power generation sheet 1 is a circular shape in plan view, the top portion of the lower edge portion of the semicircular arc shape is the bottom. By including the non-fixed portion 50 at the bottom position of the lower edge portion (lower border portion) of the photovoltaic power generation sheet 1, water that has entered between the photovoltaic power generation sheet 1 and the installation surface 3 can be discharged from the opening in the non-fixed portion 50 without being accumulated in the lower edge portion (lower border portion).

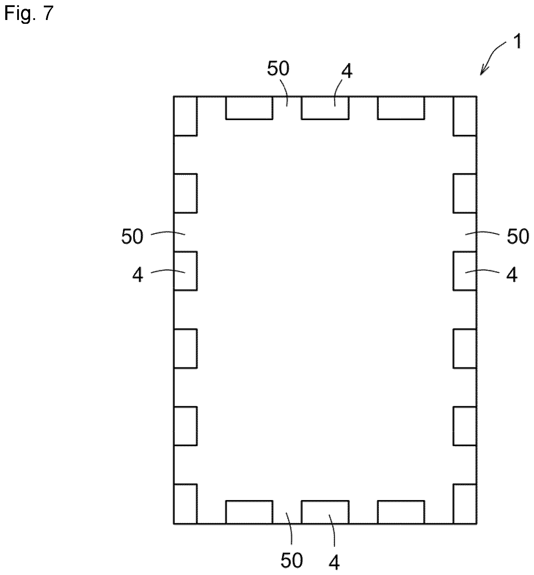

As illustrated in Fig. 7, at least one non-fixed portion 50 on the outer peripheral portion of the photovoltaic power generation sheet 1 may be provided at left and right side edge portions (left and right border portions) and/or upper edge portions (upper border portions on the upper side). In Fig. 7, a plurality of bonders 4 are provided at equal intervals on the left and right side edge portions (left and right border portions) and the upper edge portion (upper border portion on the upper side) of the photovoltaic power generation sheet 1, and a plurality of non-fixed portions 50 are provided at equal intervals. In the example of Fig. 7, when water that has entered between the photovoltaic power generation sheet 1 and the installation surface 3 is vaporized to generate steam, the steam can be discharged from the non-fixed portions 50 at the left and right side edge portions and/or the upper edge portion of the photovoltaic power generation sheet 1.

The non-fixed portion 50 of the outer peripheral portion of the photovoltaic power generation sheet 1 has such a size that the photovoltaic power generation sheet 1 does not greatly vibrate due to wind even when the wind enters between the photovoltaic power generation sheet 1 and the installation surface 3 from the opening of the non-fixed portion 50. The size of the opening in the non-fixed portion 50 is about 1 mm or more and 5 mm or less.

Since the installation surface 3 is inclined, the water that has entered between the photovoltaic power generation sheet 1 and the installation surface 3 is discharged from the non-fixed portion 50 in the lower edge portion of the photovoltaic power generation sheet 1. In the installation surface 3, a direction going up to a high position is an upper side, a direction going down to a low position is a lower side, and a direction orthogonal to the up-and-down direction and along the installation surface 3 is a lateral direction. When water such as rainwater adheres to the installation surface 3, the water flows downward on the installation surface 3. The angle formed by the installation surface 3 with respect to the horizontal plane is preferably 1.5° or more, more preferably 2° or more, and still more preferably 5° or more so that the water on the installation surface 3 can favorably flow down in the downward direction of the installation surface 3.

In the installation structure 2 according to the first embodiment, a hook-and-loop fastener such as Magic Tape (registered trademark), a magnet, a double-sided tape, or the like may be used as the sealing member instead of the bonder 4.

Next, an installation structure for a photovoltaic power generation sheet according to another embodiment of the present disclosure will be described. In the following description, points different from the first embodiment will be mainly described, and the same reference numerals will be given to points common to the first embodiment and detailed description thereof will be omitted.

### Second embodiment

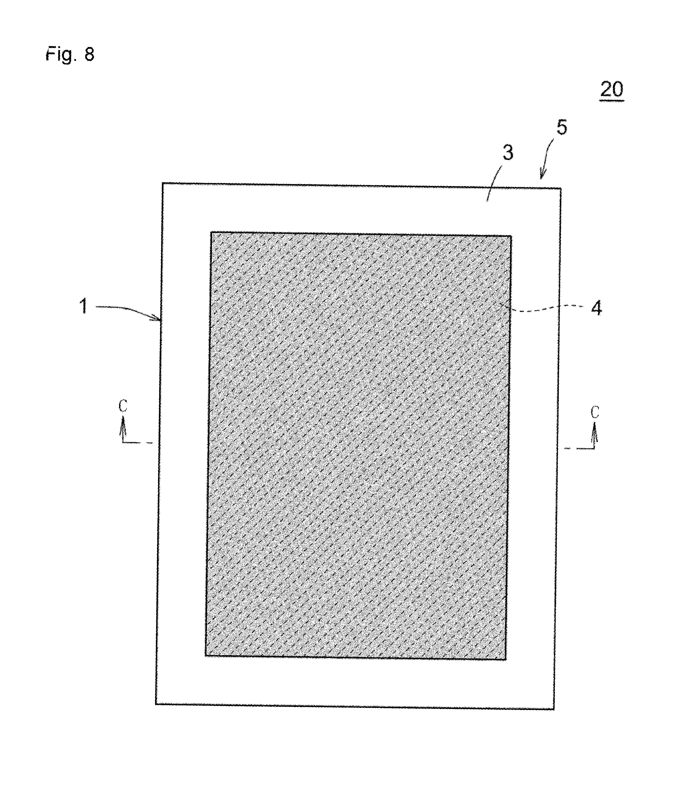

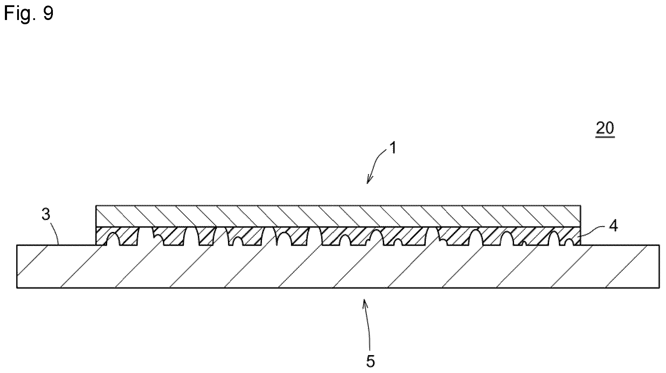

Figs. 8 and 9 illustrate an installation structure 20 for a photovoltaic power generation sheet according to a second embodiment of the present disclosure.

The installation structure 20 according to the second embodiment also includes the installation surface 3, the photovoltaic power generation sheet 1, and the bonder 4 as a sealing member that closes a gap between the outer peripheral edge of the photovoltaic power generation sheet 1 and the installation surface 3. In the installation structure 20 of the second embodiment, the bonder 4 is provided between the entire photovoltaic power generation sheet 1 and the installation surface 3. The entire photovoltaic power generation sheet 1 is bonded to the installation surface 3 by the bonder 4, whereby the photovoltaic power generation sheet 1 is fixed to the installation surface 3.

According to the installation structure 20 according to the second embodiment, in a state where the unevenness of the installation surface 3 on the lower side of the entire photovoltaic power generation sheet 1 is filled by the bonder 4, the bonder 4 bonds the entire photovoltaic power generation sheet 1 to the installation surface 3, so that it is possible to prevent generation of a gap between the entire photovoltaic power generation sheet 1 and the installation surface 3. As a result, the vibration of the photovoltaic power generation sheet 1 due to the influence of the wind can be further suppressed. In addition, since the vibration of the installation surface can be widely suppressed in the cured layer of the bonder 4, it is possible to effectively suppress the vibration of the photovoltaic power generation sheet 1 due to the influence of the vibration of the installation surface 3. Therefore, since the angle of the photovoltaic power generation sheet 1 with respect to sunlight can be more stably maintained, the power generation efficiency of the photovoltaic power generation sheet 1 can be more stably maintained.

### Third embodiment

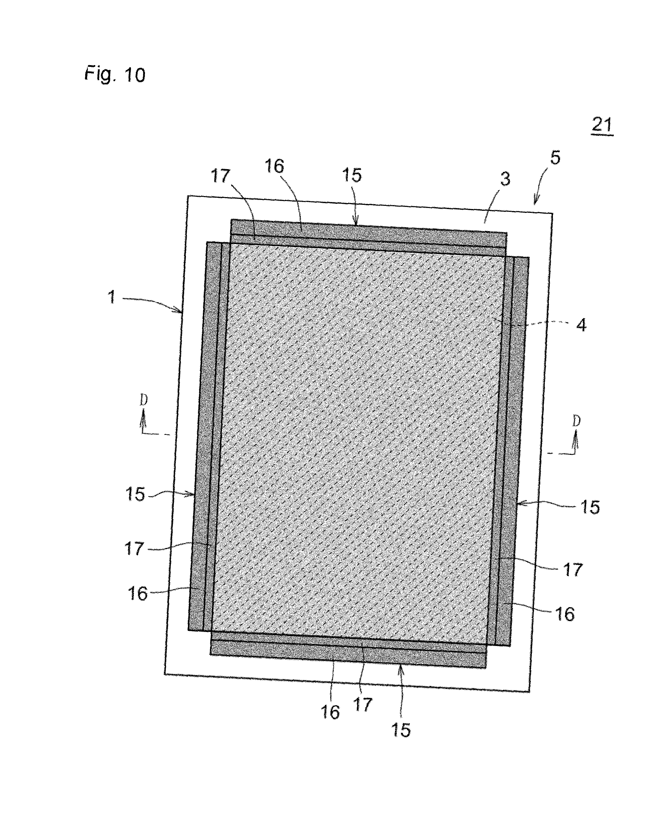

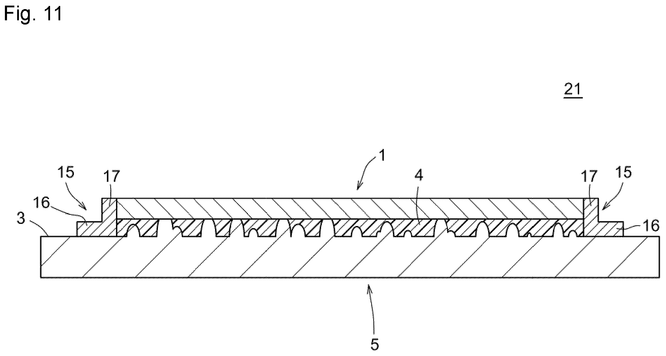

Figs. 10 and 11 illustrate an installation structure 21 for a photovoltaic power generation sheet according to a third embodiment of the present disclosure.

The installation structure 21 according to the third embodiment further includes a cover member 15 having an ultraviolet ray blocking property in addition to the configuration of the installation structure 20 illustrated in the second embodiment.

The cover member 15 includes a base portion 16 having a long and rectangular plate shape in plan view, and a cover portion 17 having a long plate shape rising from the base portion 16 along one long edge of the base portion 16. The cover member 15 has a shape in which the cover portion 17 is bent by 90° with respect to the base portion 16. The cover member 15 is installed on the installation surface 3 in such a manner that the base portion 16 is adjacent to the outside of the photovoltaic power generation sheet 1 in such a manner that the cover portion 17 is disposed along the outer peripheral edge of the photovoltaic power generation sheet 1. Thus, the cover member 15 covers the bonder 4 between the outer peripheral edge of the photovoltaic power generation sheet 1 and the installation surface 3.

According to the installation structure 21 of the third embodiment, the cover member 15 blocks the ultraviolet ray, so that the bonder 4 can be prevented from being irradiated with ultraviolet rays. As a result, deterioration of the bonder 4 due to ultraviolet rays can be suppressed, so that a state in which the photovoltaic power generation sheet 1 and the installation surface 3 are bonded by the bonder 4 can be maintained for a long period of time.

In the installation structure 21 according to the third embodiment, the bonder 4 is not necessarily provided between the entire photovoltaic power generation sheet 1 and the installation surface 3. Similarly to the installation structure 2 of the first embodiment, the bonder 4 may be provided only between the outer peripheral portion of the photovoltaic power generation sheet 1 and the installation surface 3.

### Fourth embodiment

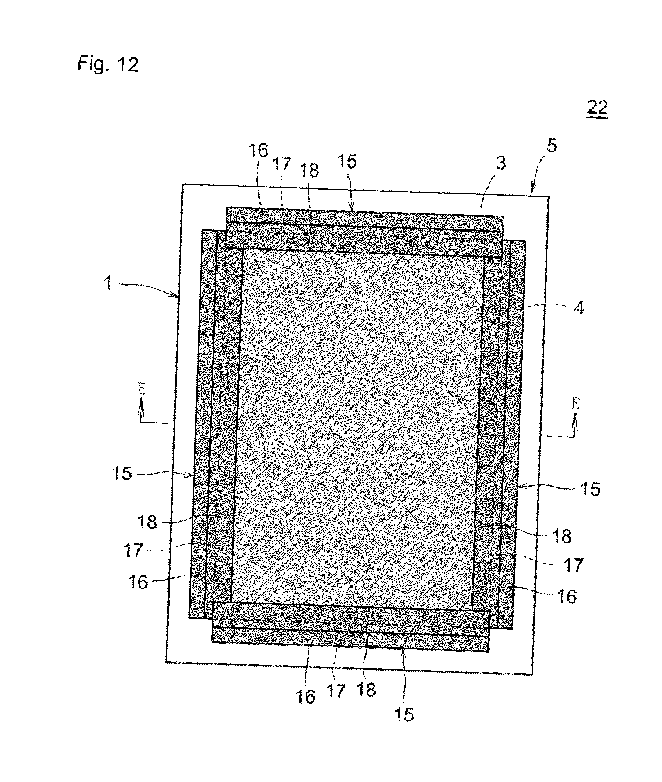

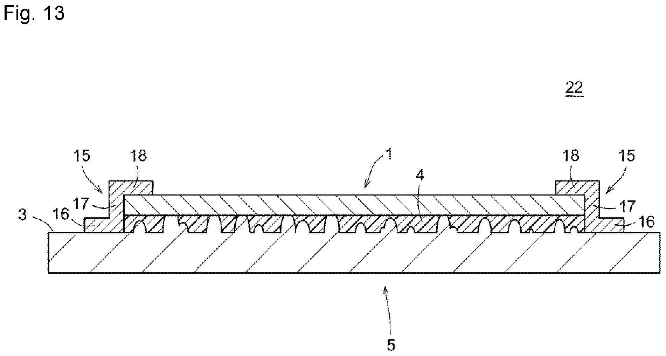

Figs. 12 and 13 illustrate an installation structure 22 of the photovoltaic power generation sheet according to a fourth embodiment of the present disclosure.

In the installation structure 22 according to the fourth embodiment, the cover member 15 has an ultraviolet ray blocking property, and includes the base portion 16 and the cover portion 17 described above, and a covered portion 18 having a long and rectangular plate shape in plan view. The covered portion 18 horizontally protrudes from the cover portion 18 at the upper end portion of the cover portion 18, and the cover member 15 has a shape in which the base portion 16 and the covered portion 18 are bent by 90° to the opposite side with respect to the cover portion 17. In the cover member 15, the base portion 16 is installed on the installation surface 3 adjacent to the outside of the photovoltaic power generation sheet 1 in such a manner that the cover portion 17 is disposed along the outer peripheral edge of the photovoltaic power generation sheet 1, and the covered portion 18 protrudes inward from the outer peripheral edge of the photovoltaic power generation sheet 1 to cover the front surface of the photovoltaic power generation sheet 1. Thus, the cover member 15 covers the bonder 4 between the outer peripheral edge of the photovoltaic power generation sheet 1 and the installation surface 3, and covers a portion having a predetermined width from the outer peripheral edge on the front surface of the photovoltaic power generation sheet 1.

According to the installation structure 21 according to the fourth embodiment, since the cover member 15 is provided with the covered portion 18, even in a case where a gap (not illustrated) is generated between the cover member 15 and the outer peripheral edge of the photovoltaic power generation sheet 1 (even in a case where the cover portion 17 of the cover member 15 is not in close contact with the outer peripheral edge of the photovoltaic power generation sheet 1), it is possible to suppress irradiation of the bonder 4 with ultraviolet rays.

In addition, by pressing the outer peripheral portion of the photovoltaic power generation sheet 1 by the covered portion 18 of the cover member 15, the fixation of the photovoltaic power generation sheet 1 to the installation surface 3 can be reinforced, and the outer peripheral portion of the photovoltaic power generation sheet 1 can be prevented from fluttering due to wind or the like. The plan view shape of the covered portion 18 is not particularly limited as long as it can press the front surface of the photovoltaic power generation sheet 1, and various shapes can be formed.

In order to press the photovoltaic power generation sheet 1 without deteriorating the power generation performance of the photovoltaic power generation sheet 1, the covered portion 18 preferably has a size that presses a range other than the power generator 7 of the photovoltaic power generation sheet 1, for example, a range of the sealing edge member 10 on the outer peripheral portion.

The lower limit of the contact pressure between the covered portion 18 and the photovoltaic power generation sheet 1 is preferably 0.5 MPa or more, more preferably 1 MPa or more, and more preferably 2.5 MPa or more, and the upper limit of the contact pressure between the covered portion 18 and the photovoltaic power generation sheet 1 is preferably 25 MPa or less, more preferably 15 MPa or less, and more preferably 10 MPa or less. This contact pressure can be measured using pressure-sensitive paper or the like. By setting the contact pressure within the above range, the covered portion 18 of the cover member 15 can appropriately press the photovoltaic power generation sheet 1, and it is possible to suppress excessive deformation of the photovoltaic power generation sheet 1 so as to inhibit the power generation efficiency.

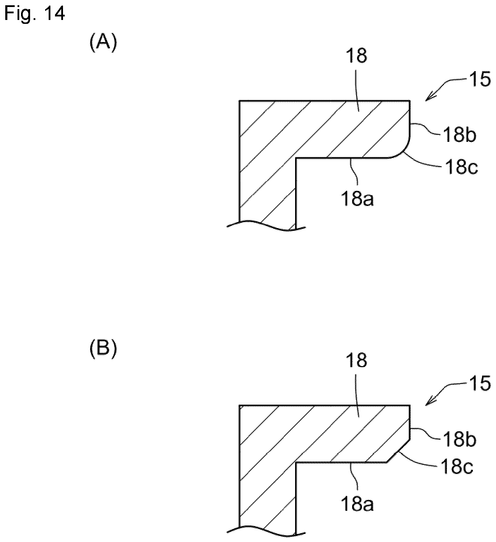

In the covered portion 18, an edge 18c between the pressing surface 18a and the side surface 18b in contact with the front surface of the photovoltaic power generation sheet 1 is preferably processed into a C surface or an R surface as illustrated in Figs. 14 (A) and 14(B). Since the edge 18c of the covered portion 18 comes into contact with the front surface of the photovoltaic power generation sheet 1 when the photovoltaic power generation sheet 1 is deformed by wind or the like, it is possible to suppress damage to the photovoltaic power generation sheet 1 due to pressing of the covered portion 18. In particular, unlike a rigid solar cell, it is difficult to predict the deformation of the photovoltaic power generation sheet 1 that is easily elastically deformed due to wind or the like. Therefore, it is possible to stably install the photovoltaic power generation sheet 1 for a longer period of time by effectively suppressing the stress concentration at the contact location with the edge 18c of the covered portion 18. As another method for suppressing stress concentration at a contact portion with the edge 18c of the covered portion 18, a spacer or the like having elasticity may be provided between the photovoltaic power generation sheet 1 and the covered portion 18. The material of the elastic member is not particularly limited, and examples thereof include rubber, resin, and metal washers.

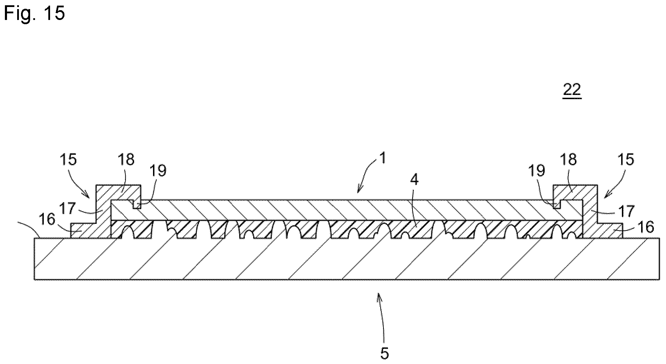

As illustrated in Fig. 15, the covered portion 18 of the cover member 15 is provided with an elongated convex portion 19 protruding from the lower surface. The convex portion 19 extends in the length direction of the covered portion 18. In the cover member 15, the convex portion 19 is provided on the covered portion 18 in contact with the front surface of the photovoltaic power generation sheet 1, so that the outer peripheral portion of the photovoltaic power generation sheet 1 is compressed by the convex portion 19. As a result, it is possible to suppress water from entering between the covered portion 18 of the cover member 15 and the photovoltaic power generation sheet 1, and it is possible to improve water-blocking performance of the photovoltaic power generation sheet 1, so that the photovoltaic power generation sheet 1 can be stably installed for a longer period of time. From the viewpoint of not deteriorating the power generation performance of the photovoltaic power generation sheet 1, it is preferable that the convex portion 19 is provided in the covered portion 18 in such a manner that the convex portion 19 is in contact with a range other than the power generator 7 of the photovoltaic power generation sheet 1, for example, a range of the sealing edge member 10 of the outer peripheral portion.

With the thickness of the photovoltaic power generation sheet 1 being 100%, the lower limit of the crushing ratio of the photovoltaic power generation sheet 1 by the convex portion 19 is preferably 1% or more, more preferably 5% or more, and more preferably 10%, and the upper limit of the crushing ratio of the photovoltaic power generation sheet 1 by the convex portion 19 is preferably 25% or less, more preferably 20% or less, and more preferably 15% or less. When the crushing ratio is in the above range, it is possible to suppress excessive deformation of the photovoltaic power generation sheet 1 so as to inhibit the power generation efficiency while appropriately improving the water-blocking performance of the photovoltaic power generation sheet 1.

In the installation structure 22 according to the fourth embodiment, the bonder 4 is not necessarily provided between the entire photovoltaic power generation sheet 1 and the installation surface 3. Similarly to the installation structure 2 of the first embodiment, the bonder 4 may be provided only between the outer peripheral portion of the photovoltaic power generation sheet 1 and the installation surface 3.

The material of the cover member 15 illustrated in the third and fourth embodiments is not particularly limited as long as it has an ultraviolet ray blocking property. As the cover member 15, for example, a frame made of metal such as aluminum, resin, composite reinforced material, or the like can be used. The cover member 15 can be fixed to the installation surface 3 at the base portion 16 using, for example, a bolt or a bonder.

As illustrated in Figs. 10 and 12, the entire circumference of the photovoltaic power generation sheet 1 is surrounded by the cover portion 17 of the cover member 15, so that it is possible to suppress deterioration of the bonder 4 over the entire circumference. In order to surround the entire circumference of the photovoltaic power generation sheet 1 with the cover portion 17 of the cover member 15, a plurality of (four in the illustrated example) linear cover members 15 are prepared in Figs. 10 and 12, and linear cover members 15 are installed for the respective border portions of the photovoltaic power generation sheet 1. In order to surround the entire circumference of the photovoltaic power generation sheet 1 with the cover portion 17 of the cover member 15, for example, one annular cover member may be prepared, and an annular cover member may be installed around the photovoltaic power generation sheet 1.

Note that the present disclosure does not exclude a case where the entire circumference of the photovoltaic power generation sheet 1 is not surrounded by the cover portion 17 of the cover member 15. For example, the cover member 15 including the plate-shaped cover portion 17 may be provided only on a part of the periphery of the photovoltaic power generation sheet 1, or the cover member 15 may be provided on the entire circumference of the photovoltaic power generation sheet 1, and the cover portion 17 may have a rod shape arranged at a plurality of intervals instead of one plate shape. Even in this case, it is possible to suppress irradiation of the bonder 4 with ultraviolet rays at the location where the cover member 15 is provided, so that it is possible to suppress deterioration of the bonder 4.

The cover member 15 may not include the base portion 16, and may be fixed to the installation surface 3 by extending the cover portion 17 downward and embedding the cover portion 17 in the installation surface 3. In this case, it is preferable that the cover portion 17 is provided with a protrusion or the like on the outer peripheral surface so that the cover portion 17 is easily embedded with respect to the installation surface 3 and the embedded cover portion 17 is hardly removed from the installation surface 3. In addition, it is preferable that a large contact area between the installation surface 3 and the cover portion 17 embedded in the installation surface 3 is secured by making the cover portion 17 hollow, and the embedded cover portion 17 is hardly removed from the installation surface 3. In a case where the cover portion 17 is hollow, a protrusion or the like may be provided on the inner peripheral surface of the cover portion 17 to make it difficult for the embedded cover portion 17 to come off from the installation surface 3.

In the installation structures 21 and 22 according to the third and fourth embodiments, the covered material covering the bonder 4 between the outer peripheral edge of the photovoltaic power generation sheet 1 and the installation surface 3 may be a joint material such as cement instead of the cover member 15 described above. In the construction site, the joint material may be applied around the photovoltaic power generation sheet 1 in such a manner of covering the bonder 4 between the outer peripheral edge of the photovoltaic power generation sheet 1 and the installation surface 3.

### Modifications

The installation structure for the present disclosure is not limited to the installation structure for the above embodiment, and can be variously modified.

In the installation structure for the above embodiment, the gap between the photovoltaic power generation sheet 1 and the installation surface 3 is filled with a single bonder 4. In the installation structure for the present disclosure, the bonder 4 may include a first bonder for bonding the installation surface 3 and the filler, and a second bonder for bonding the filler and the photovoltaic power generation sheet 1. Even in this case, the same effects as those of the installation structure for the above embodiment can be obtained. The viscosity of the filler is preferably 800cP or more.

In the installation structure for the present disclosure, in addition to fixing the photovoltaic power generation sheet 1 to the installation surface 3 with the bonder 4, the photovoltaic power generation sheet 1 may be fixed to the installation surface 3 using a fixing member.

The fixing member is not particularly limited, and examples thereof include a flange member having a flange portion such as a bolt or a rivet, a sandwiching member, and a staple. Examples of the sandwiching member include a clamp and a vise. The photovoltaic power generation sheet 1 can be fixed to the installation surface 3 with a higher fixing force without deteriorating the power generation performance of the photovoltaic power generation sheet 1 by the flange member or the sandwiching member disposed in the range other than the power generator 7 of the photovoltaic power generation sheet 1, for example, in the range of the sealing edge member 10 on the outer peripheral portion. The flange member or the sandwiching member may be fixed to the outer peripheral portion of the photovoltaic power generation sheet 1 on a part of the outer peripheral portion or over the entire circumference.

Other examples of the fixing member include hanging members such as a hook, a lock, and an L-shaped hook. By allowing the hanging member to penetrate a range of the photovoltaic power generation sheet 1 other than the power generator 7, for example, a range of the sealing edge member 10 on the outer peripheral portion, the photovoltaic power generation sheet 1 can be fixed to the installation surface 3 with a higher fixing force without deteriorating the power generation performance of the photovoltaic power generation sheet 1. A fixing hole through which the hanging member passes may be formed in advance in the photovoltaic power generation sheet 1, or a fixing hole may be formed by pressing the photovoltaic power generation sheet 1 against the hanging member at the time of construction. In a case where a fixing hole is formed in the photovoltaic power generation sheet 1 in advance, the inside of the fixing hole and the peripheral edge portion of the fixing hole may be covered with metal, resin, or the like. As a result, when the photovoltaic power generation sheet 1 is installed, it is possible to suppress cracking and breakage from the fixing hole due to strong wind, vibration, or the like.

The material of the flange member, the sandwiching member, and the hanging member described above is not particularly limited, and examples thereof include a metal, a resin, a composite reinforced material, and the like. Examples of the metal include aluminum, SUS, and a coated metal member. Examples of the resin include polypropylene, polyethylene, hard vinyl chloride, polycarbonate, polyamide, and PPS. Examples of the composite reinforced material include those containing the resin, carbon, glass, and metal fibers. The flange member, the sandwiching member, and the hanging member are fixed to the installation surface 3. The fixing method with respect to the installation surface 3 is not particularly limited, and examples thereof include bonding, sandwiching, bolt/nut, pinning, welding, welding, and screwing with respect to the installation surface 3.

In the installation structure for the above embodiment, the bonder 4 suppresses vibration of the photovoltaic power generation sheet 1 due to the influence of wind, and suppresses vibration caused by vibration of the installation surface 3. In the installation structure for the present disclosure, in a case where the installation surface 3 is less likely to vibrate and only the vibration of the photovoltaic power generation sheet 1 due to the influence of wind needs to be considered, the cover member 15 described above may be used as a sealing member, and the cover member 15 may be installed around the photovoltaic power generation sheet 1 instead of the bonder 4. By suppressing the wind from entering between the photovoltaic power generation sheet 1 and the installation surface 3 by the cover member 15, it is possible to suppress the vibration of the photovoltaic power generation sheet 1 due to the influence of the wind.

In addition, the sealing member of the present disclosure may use a joint material, and a gap between at least the outer peripheral portion of the photovoltaic power generation sheet 1 and the installation surface 3 may be filled with the joint material instead of the bonder 4. By suppressing wind from entering between the photovoltaic power generation sheet 1 and the installation surface 3 by the joint material, vibration of the photovoltaic power generation sheet 1 due to the influence of wind can be suppressed.

As the joint material, a high-viscosity resin, cement, or the like can be used. The lower limit of the viscosity of the joint material is preferably 0.1 Pa·s or more, more preferably 10 Pa·s or more, and the upper limit of the viscosity of the joint material is preferably 10,000 Pa·s or less, more preferably 1000 Pa·s or less. When the viscosity of the joint material is in the above range, the shape of the joint material can be maintained not only in the horizontal direction but also in the vertical direction, so that the gap between the photovoltaic power generation sheet 1 and the installation surface 3 can be effectively filled. Furthermore, when the joint material is applied to the installation surface 3 or the photovoltaic power generation sheet 1, the joint material can be easily expanded, so that construction can be improved.

The joint material may be provided only between the outer peripheral portion of the photovoltaic power generation sheet 1 and the installation surface 3. Regarding the width of the joint material, the lower limit is preferably 5 mm or more, more preferably 100 mm or more, more preferably 150 mm or more, and the upper limit is 250 mm or less, more preferably 200 mm or less, more preferably 175 mm or less as the length in the direction from the outer peripheral edge of the photovoltaic power generation sheet 1 toward the inside along the installation surface 3. When the width of the joint material is in the above range, the vibration of the photovoltaic power generation sheet 1 due to the influence of wind can be effectively suppressed, and at the same time, the weight load on the installation surface 3 can be reduced, and the photovoltaic power generation sheet 1 can also be installed on the installation surface 3 such as a fragile roof.

In a case where a joint material is used as the sealing member, a cavity closed to the outside is generated between the photovoltaic power generation sheet 1 and the installation surface 3. When the air in the cavity expands or contracts due to a temperature change, stress is generated in the photovoltaic power generation sheet 1 in a direction perpendicular to the installation surface 3, and the photovoltaic power generation sheet 1 may be broken. In order to suppress breakage of the photovoltaic power generation sheet 1 due to this cause, it is preferable to use a porous material as the joint material, or it is preferable to form an air hole in the joint material. Thus, the photovoltaic power generation sheet 1 can be stably installed for a longer period of time. The lower limit of the size of the air hole is preferably 20mm² or more, more preferably 25mm² or more, more preferably 50mm² or more, and the upper limit is preferably 200mm² or less, more preferably 150mm² or less, more preferably 100mm² or less as the total area. When the size of the air hole is in the above range, the air expanded or contracted by the temperature change and the external air can be appropriately exchanged, and the generated stress can be reduced. In addition, since rainwater can be suppressed from entering the air hole, deterioration of the photovoltaic power generation sheet 1 due to rainwater can be suppressed. The air hole is preferably provided with a gradient so that rainwater is less likely to enter from the outside to the inside of the joint material.

In addition to the cover member 15 and the joint material, for example, a lid member made of a hard resin, metal, or ceramic may be used as the sealing member of the present disclosure, and the gap between the outer peripheral edge of the photovoltaic power generation sheet 1 and the installation surface 3 may be closed by the lid member to suppress the air from entering between the photovoltaic power generation sheet 1 and the installation surface 3. As a result, it is possible to suppress the vibration of the photovoltaic power generation sheet 1 due to the influence of the wind.

In the installation structure for the present disclosure, in a case where the bonder 4 is not used as the sealing member, the photovoltaic power generation sheet 1 may be fixed to the installation surface 3 by the bonder 4. In a case where the photovoltaic power generation sheet 1 is fixed to the installation surface 3 by the bonder 4, as long as the bonder 4 can bond the photovoltaic power generation sheet 1 to the installation surface 3, it is not necessary to bond the entire photovoltaic power generation sheet 1 or the entire circumference of the outer peripheral portion of the photovoltaic power generation sheet 1 to the installation surface 3. The photovoltaic power generation sheet 1 may be fixed to the installation surface 3 using the fixing member described above instead of the bonder 4, and it is preferable to fix the photovoltaic power generation sheet 1 using the bonder 4 from the viewpoint of suppressing breakage of the photovoltaic power generation sheet 1. Note that in a case where a joint material is used as the sealing member, the bonder 4 and the above-mentioned fixing member are not necessarily required as long as the photovoltaic power generation sheet 1 can be fixed to the installation surface 3 by the joint material.

In addition, in a case where the photovoltaic power generation sheet 1 is fixed to the installation surface 3 by the bonder 4 without using the bonder 4 as a sealing member, it is preferable that there is no possibility that the power generator 7 of the photovoltaic power generation sheet 1 is bent and broken when the photovoltaic power generation sheet 1 needs to be peeled off and recovered from the installation surface 3.

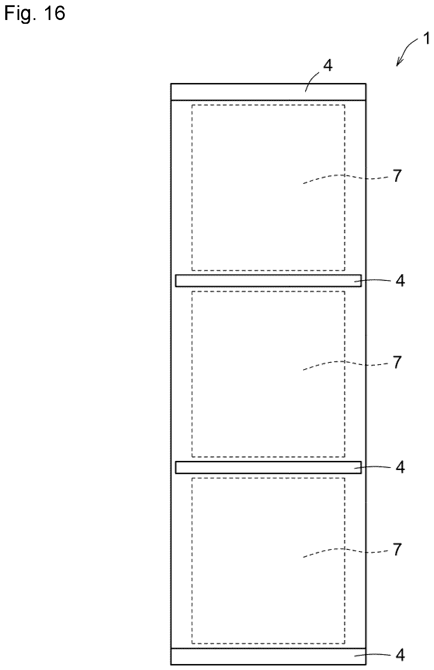

Specifically, as illustrated in Fig. 16, it is preferable that the bonder 4 extends in one direction (lateral direction in Fig. 16) of the photovoltaic power generation sheet 1 and is disposed at intervals in another direction (longitudinal direction in Fig. 16) orthogonal to the one direction. In Fig. 16, the bonder 4 extends in the shortitudinal direction of the photovoltaic power generation sheet 1 having a rectangular shape in plan view, and is disposed at intervals in the longitudinal direction.

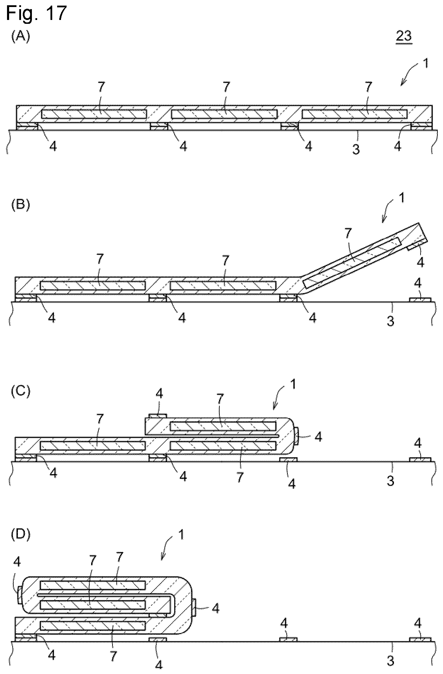

As illustrated in Fig. 17(A), the bonder 4 fixes a portion of the photovoltaic power generation sheet 1 to the installation surface 3. The entire photovoltaic power generation sheet 1 is not fixed to the installation surface 3 by the bonder 4, and the entire circumference of the outer peripheral portion is not fixed to the installation surface 3. Therefore, the photovoltaic power generation sheet 1 includes a non-fixed portion that is not fixed to the installation surface 3 on the inner side of the outer peripheral portion, and also includes a non-fixed portion that is not fixed to the installation surface 3 on the outer peripheral portion.

The bonder 4 is provided in a portion avoiding the power generator 7 in the photovoltaic power generation sheet 1 (a portion not overlapping the power generator 7 in plan view). For example, the bonder 4 is provided at a boundary portion between adjacent power generators 7. In this case, from the viewpoint of firmly fixing the photovoltaic power generation sheet 1 to the installation surface 3, it is preferable that the bonder 4 is provided at all the boundary portions. That is, it is preferable that the bonders 4 are provided at intervals in the longitudinal direction of the photovoltaic power generation sheet 1 in such a manner of sandwiching the respective power generators 7 from both sides.

Next, an example of a method of peeling off the photovoltaic power generation sheet 1 from the installation surface 3 will be described. When the photovoltaic power sheet 1 is peeled off, as illustrated in Fig. 17 (B), first, the fixation of the photovoltaic power generation sheet 1 and the installation surface 3 by the bonder 4 positioned at one end in the longitudinal direction is removed from the bonders 4 disposed at intervals in the longitudinal direction of the photovoltaic power generation sheet 1. As a result, in the photovoltaic power generation sheet 1, a portion (the power generator 7 and the like) adjacent to the released bonder 4 can be peeled off from the installation surface 3 without any difficulty. In the photovoltaic power generation sheet 1, the portion peeled off from the installation surface 3 is folded over the remaining portion.

Then, as illustrated in Fig. 17(C), the fixation of the photovoltaic power generation sheet 1 and the installation surface 3 by the bonder 4 positioned next in the longitudinal direction is released. As a result, in the photovoltaic power generation sheet 1, a portion (the power generator 7 and the like) adjacent to the released bonder 4 can be peeled off from the installation surface 3 without any difficulty. In the photovoltaic power generation sheet 1, the portion peeled off from the installation surface 3 is folded over the remaining portion.

Finally, as illustrated in Fig. 17(D), the fixation of the photovoltaic power generation sheet 1 and the installation surface 3 by the bonder 4 positioned at the other end in the longitudinal direction is removed. As a result, the entire photovoltaic power generation sheet 1 can be peeled off from the installation surface 3 to collect the photovoltaic power generation sheet 1.

According to this method, when the photovoltaic power generation sheet 1 is peeled off from the installation surface 3, the power generator 7 is not bent and stress is not concentrated on the power generator 7, so that the photovoltaic power generation sheet 1 can be easily peeled off from the installation surface 3 while suppressing breakage of the power generator 7. In addition, since the photovoltaic power generation sheet 1 can be peeled off from the installation surface 3 while being compactly folded, the photovoltaic power generation sheet 1 can be suppressed from being blown by the wind even in an environment where the wind is strong on a roof or the like, and the photovoltaic power generation sheet 1 can be easily peeled off from the installation surface 3.

In the installation structure 23 illustrated in Fig. 17, as a fixing member for fixing the photovoltaic power generation sheet 1 to the installation surface 3, a hook-and-loop fastener such as Magic Tape (registered trademark), a magnet, a double-sided tape, or the like may be used in addition to the bonder 4.

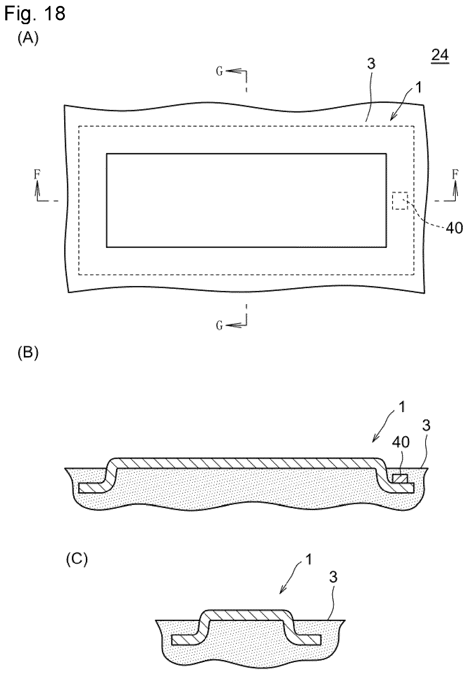

Furthermore, as another example, in a case where the installation surface 3 is a surface of ground on which soil, sand, gravel, or the like is deposited, or a surface of ground formed of concrete, asphalt, or the like, the sealing member of the present disclosure may use a material constituting the installation surface 3 as illustrated in Fig. 18.

In the installation structure 24 illustrated in Fig. 18, the photovoltaic power generation sheet 1 is installed on the installation surface 3 by embedding the outer peripheral portion under the installation surface 3. In order not to deteriorate the power generation performance of the photovoltaic power generation sheet 1, it is preferable to embed a range other than the power generator 7 of the photovoltaic power generation sheet 1, for example, a range of the sealing edge member 10 of the outer peripheral portion under the installation surface 3. Since the outer peripheral portion of the photovoltaic power generation sheet 1 is embedded under the installation surface 3, the photovoltaic power generation sheet 1 is fixed to the installation surface 3, and the gap between the outer peripheral edge of the photovoltaic power generation sheet 1 and the installation surface 3 is closed by the material forming the installation surface 3. As a result, it is possible to suppress wind from entering between the photovoltaic power generation sheet 1 and the installation surface 3, and it is possible to suppress vibration of the photovoltaic power generation sheet 1 the due to the influence of the wind. Since the power generator 7 of the photovoltaic power generation sheet 1 is exposed on the installation surface 3, the photovoltaic power generation sheet 1 generates power favorably.

Regarding the installation structure 24 illustrated in Fig. 18, in a case where it is necessary to separately fix the photovoltaic power generation sheet 1 and the installation surface 3, the photovoltaic power generation sheet 1 and the installation surface 3 are fixed using a bonder or the fixture described above. For example, in the photovoltaic power generation sheet 1, a portion exposed on the installation surface 3 may be fixed to the installation surface 3 with a bonder, or a portion embedded under the installation surface 3 may be fixed to the ground or the like under the installation surface 3 using the fixture described above.

In the installation structure 24 illustrated in Fig. 18, the upper layer and the lower layer sandwiching the outer peripheral portion of the photovoltaic power generation sheet 1 embedded under the installation surface 3 may have the same or different geologies. For example, the photovoltaic power generation sheet 1 may be placed on a layer on which soil, sand, gravel, or the like is deposited, and a layer in which concrete or the like is solidified may be provided on the outer peripheral portion of the photovoltaic power generation sheet 1, so that the outer peripheral portion of the photovoltaic power generation sheet 1 may be embedded under the installation surface 3.

In the installation structure 24 illustrated in Fig. 18, the outer peripheral portion of the photovoltaic power generation sheet 1 is bent downward and embedded under the installation surface 3. The outer peripheral portion of the photovoltaic power generation sheet 1 can be embedded under the installation surface 3 without being bent downward, in this case, soil, sand, gravel, and the like are highly accumulated on the outer peripheral portion of the photovoltaic power generation sheet 1. In this case, there is a possibility that sunlight incident on the power generator 7 of the photovoltaic power generation sheet 1 is blocked by highly deposited soil, sand, gravel, or the like, and there is a possibility that the power generation amount of the photovoltaic power generation sheet 1 decreases. On the other hand, as in the installation structure 24 illustrated in Fig. 18, since the outer peripheral portion of the photovoltaic power generation sheet 1 is bent downward and embedded under the installation surface 3 at a position lower than the power generator 7, sunlight incident on the power generator 7 of the photovoltaic power generation sheet 1 is not blocked, so that it is possible to prevent a decrease in the amount of power generation of the photovoltaic power generation sheet 1.

In the installation structure 24 illustrated in Fig. 18, an electric box 40 for outputting electricity generated by the power generator 7 of the photovoltaic power generation sheet 1 to an external device such as a power conditioner is preferably disposed in a portion of the outer peripheral portion of the photovoltaic power generation sheet 1 and embedded under the installation surface 3. As a result, the electric box 40 can be prevented from being exposed to wind and rain or sunlight, so that the durability of the electric box 40 can be improved. The electric box 40 may be disposed on another portion of the outer peripheral portion of the photovoltaic power generation sheet 1 and exposed on the installation surface 3. When the electric box 40 is exposed on the installation surface 3, maintainability can be improved when the electric box 40 is broken or when connection failure occurs.

In the installation structure 24 illustrated in Fig. 18, the outer peripheral portion of the photovoltaic power generation sheet 1 is embedded under the installation surface 3 over the entire circumference. However, only a portion of the outer peripheral portion of the photovoltaic power generation sheet 1 may be embedded under the installation surface 3, and the remaining portion may be exposed on the installation surface 3. In this case, the gap between the outer peripheral edge of the photovoltaic power generation sheet 1 and the installation surface 3 can be closed using the other sealing member described above.

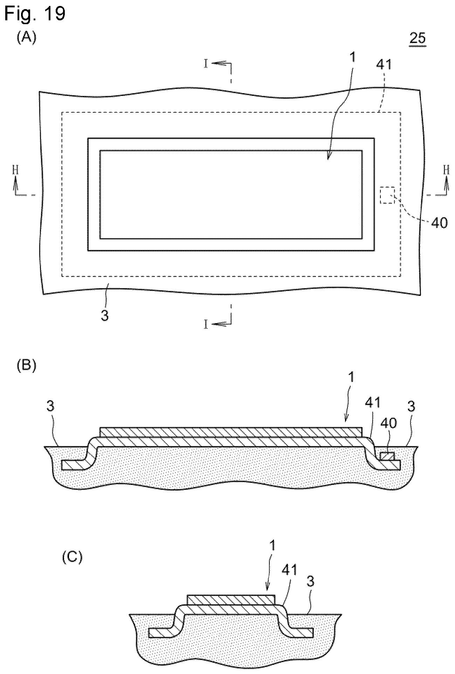

In the installation structure for the present disclosure, the photovoltaic power generation sheet 1 may be installed on the installation surface 3 via a sheet member such as a resin sheet, and in this case, the surface of the sheet member also becomes the installation surface 3. Examples of the sheet member include a fiber-containing sheet 41 illustrated in Fig. 19.

The fiber-containing sheet 41 is a sheet containing fibers. As the fiber-containing sheet 41, a fiber-reinforced sheet in which the periphery of fibers is covered with a resin, or a nonwoven fabric can be used. In this case, for example, polyethylene, polypropylene, polyester, polylactic acid, polyolefin, asphalt, and silica sand are used as the material of fibers contained in the fiber-containing sheet 41. The thickness of the fiber-containing sheet 41 is preferably 0.1 mm or more and 100 mm or less. Since the installation surface 3 is covered with the fiber-containing sheet 41 and is blocked from being irradiated with sunlight, it is possible to suppress vegetation from being generated and growing on the installation surface 3.

The plan view shape of the fiber-containing sheet 41 is not particularly limited, and may be various shapes such as a rectangular shape such as a rectangular shape, a circular shape, an elliptical shape, and a polygonal shape. The fiber-containing sheet 41 can be formed in the same shape and the same size as the photovoltaic power generation sheet 1, and is preferably formed to be slightly larger than the photovoltaic power generation sheet 1 as illustrated in Fig. 19. Thus, for example, the photovoltaic power generation sheet 1 can be installed on the installation surface 3 by embedding the outer peripheral portion of the fiber-containing sheet 41 under the installation surface 3 over the entire circumference and laying and fixing the fiber-containing sheet 41 on the installation surface 3. In this case, in the photovoltaic power generation sheet 1, the gap between the outer peripheral edge and the surface of the fiber-containing sheet 41 is closed by a sealing member such as a bonder, so that it is possible to suppress wind from entering between the photovoltaic power generation sheet 1 and the installation surface 3, and it is possible to suppress vibration of the photovoltaic power generation sheet 1 due to the influence of the wind.

Further, in the installation structure for the present disclosure, the installation surface 3 may be a corrugated surface in which a plurality of crest portions and a plurality of valley portions are bent in such a manner of being alternately arranged in addition to a flat horizontal plane without inclination. In a case where the installation surface 3 is a corrugated surface, the maximum flexural radius of the photovoltaic power generation sheet 1 is preferably 50 mm or more, more preferably 75 mm or more, and more preferably 100 mm or more. When the maximum flexural radius of the photovoltaic power generation sheet 1 is in the above range, the photovoltaic power generation sheet 1 can be deformed while being prevented from being broken according to the shape of the installation surface 3 having a wave shape, and the photovoltaic power generation sheet 1 can be installed on the installation surfaces 3 having various shapes.

The lower limit of the flexural radius of the power generator 7 of the photovoltaic power generation sheet 1 is preferably 50 mm or more, more preferably 75 mm or more, and more preferably 100 mm or more, and the upper limit of the flexural radius of the power generator 7 is preferably 300 mm or less, more preferably 200 mm or less, and more preferably 150 mm or less. When the flexural radius of the power generator 7 is in the above range, the power generator 7 of the photovoltaic power generation sheet 1 can be improved in followability to various shapes of the installation surface 3 while suppressing breakage, and an effective light receiving surface area can be increased.

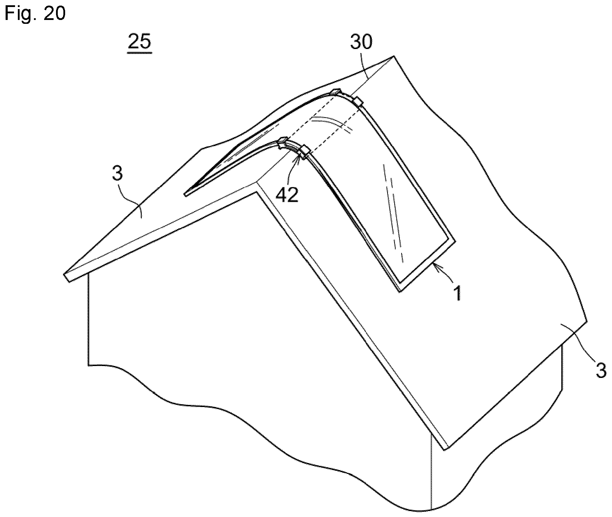

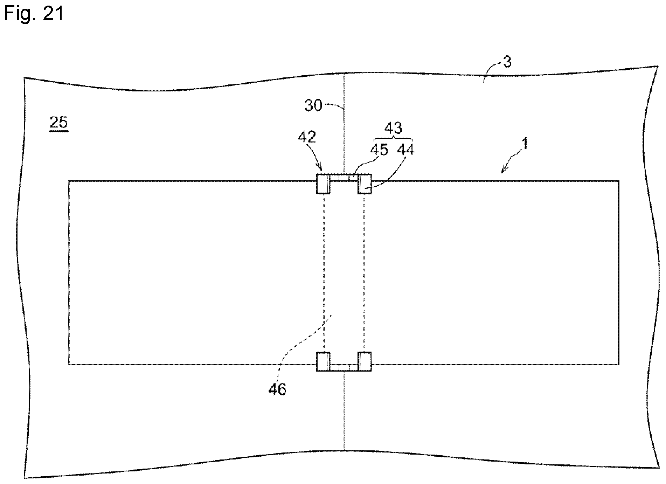

In the installation structure for the present disclosure, the installation surface 3 may have a corner portion 30 as illustrated in Figs. 20 and 21. When the photovoltaic power generation sheet 1 is installed on the installation surface 3 across the corner portion 30, the photovoltaic power generation sheet 1 may be damaged at the corner portion 30. Therefore, even when the photovoltaic power generation sheet 1 is installed on the installation surface 3 across the corner portion 30, it is necessary to make damage unlikely to occur. The corner portion 30 refers to a protruding corner portion that is adjacent to at least one installation surface 3 and protrudes in a convex shape. Examples of the corner portion 30 include a ridge of a roof, an upper corner of a sparkle, and an upper corner of an eaves edge. The ridge includes a large ridge, a getting-off ridge (corner ridge), and a juvenile ridge. The ridge also includes an upper end portion of a side roof. The roof of this type is not particularly limited, and examples thereof include a gable roof, a hip roof, a side roof, a square roof, a purlin roof, a sloped roof, a passable roof, a sawtooth roof, and a peg roof. The building having a roof may be a non-residential building or a residential building. Examples of the non-residential building include a store, a warehouse, a factory, a meeting place, a gymnasium, a parking lot, and the like. Examples of the residential building include a wooden house, a steel frame house, a reinforced concrete house, and an aluminum house. In addition, the installation surface 3 having the corner portion 30 is not limited to the roof, and examples thereof include a wall surface, a floor surface, and the like having a stepped convex portion and/or a local convex portion. Examples of the wall surface include wall surfaces formed of concrete, metal siding, a wooden wall plate, a soil wall, and the like. In the installation structure 25 illustrated in Figs. 20 and 21, a case where the photovoltaic power generation sheet 1 is installed across a large ridge with respect to a gable roof will be described as an example.

An installation structure 25 illustrated in Figs. 20 and 21 includes an installation surface 3, a photovoltaic power generation sheet 1, and a spacer member 42. Since the photovoltaic power generation sheet 1 is installed on the installation surface 3 in a state of being attached to the spacer member 42, it is possible to suppress the corner portion 30 of the installation surface 3 from strongly hitting the photovoltaic power generation sheet 1. The spacer member 42 preferably keeps the corner portion 30 of the installation surface 3 and the photovoltaic power generation sheet 1 in a non-contact state. The spacer member 42 includes a spacer 46 and at least one attachment portion 43 (a pair in Figs. 20 and 21).

In the installation structure 25 illustrated in Figs. 20 and 21, one of the pair of attachment portions 43 is attached to one end portion of the photovoltaic power generation sheet 1 in the width direction, and the other of the pair of attachment portions 43 is attached to the other end portion of the photovoltaic power generation sheet 1 in the width direction. The spacer 46 is disposed between the photovoltaic power generation sheet 1 and the corner portion 30 of the installation surface 3 by the attachment portion 43. As a result, even when the photovoltaic power generation sheet 1 is installed across the corner portion 30 with respect to the installation surface 3 having the corner portion 30, it is possible to suppress the photovoltaic power generation sheet 1 from being damaged by the corner portion 30. The spacer member 42 may be attached to the photovoltaic power generation sheet 1 in a retrofitting manner at a construction site or may be attached at the time of factory shipment.

Since the spacer 46 is disposed between the corner portion 30 of the installation surface 3 and the photovoltaic power generation sheet 1, an external force applied to the photovoltaic power generation sheet 1 from the corner portion 30 can be reduced. The lower limit of the thickness of the spacer 46 is preferably 1 mm or more, more preferably 3 mm or more, and more preferably 5 mm or more, and the upper limit of the thickness of the spacer 46 is preferably 20 mm or less, more preferably 15 mm or less, and more preferably 10 mm or less. When the thickness of the spacer 46 is in the above range, it is possible to suppress damage at a contact portion between the corner portion 30 of the installation surface 3 and the photovoltaic power generation sheet 1.

The spacer 46 preferably keeps the corner portion 30 of the installation surface 3 and the photovoltaic power generation sheet 1 in a non-contact state. In order to keep the corner portion 30 of the installation surface 3 and the photovoltaic power generation sheet 1 in a non-contact state, the spacer 46 is formed to extend from one end portion to the other end portion of the photovoltaic power generation sheet 1 in the direction in which the corner portion 30 extends. That is, the spacer 46 extends over the entire length in the width direction of the photovoltaic power generation sheet 1. In this case, the spacer 46 may be longer than the width of the photovoltaic power generation sheet 1 as long as the spacer 46 extends over the entire length in the width direction of the photovoltaic power generation sheet 1.

Examples of the material of the spacer 46 include synthetic resin, metal, carbon, pulp, natural rubber, and ceramic. From the viewpoint of being used outdoors, examples of the material of the spacer 46 include polypropylene, polyethylene, ABS resin, polyvinyl chloride, methacrylic resin, phenol resin, epoxy resin, polyurethane resin, melamine resin, unsaturated polyester resin, PPS, NBR, SBR and the like as long as the material of the spacer 46 is a synthetic resin. Examples of the metal include an aluminum alloy, a stainless alloy, steel, niobium, a nickel alloy, zirconium, chromium, and a titanium alloy. Here, since the spacer 46 is covered with the photovoltaic power generation sheet 1, high weather resistance is not necessarily required. The spacer 46 may be formed of one material among the above-described materials, or may be formed of a plurality of materials. Further, the spacer 46 may be formed of one layer or a plurality of layers.

The edges 48 on both sides of the upper surface of the spacer 46 are preferably chamfered. Since the edge 48 of the spacer 46 comes into contact with the back surface of the photovoltaic power generation sheet 1 when the spacer 46 supports the photovoltaic power generation sheet 1, the damage to the photovoltaic power generation sheet 1 can be further suppressed by performing chamfering. The chamfering may be C-face machining or R-face machining.

The attachment portion 43 includes a plurality of upper facing portions 44 and a plurality of joint portions 45. In the present embodiment, one of the pair of attachment portions 43 is attached to one end portion of the photovoltaic power generation sheet 1 in the width direction, and the other of the pair of attachment portions 43 is attached to the other end portion of the photovoltaic power generation sheet 1 in the width direction.

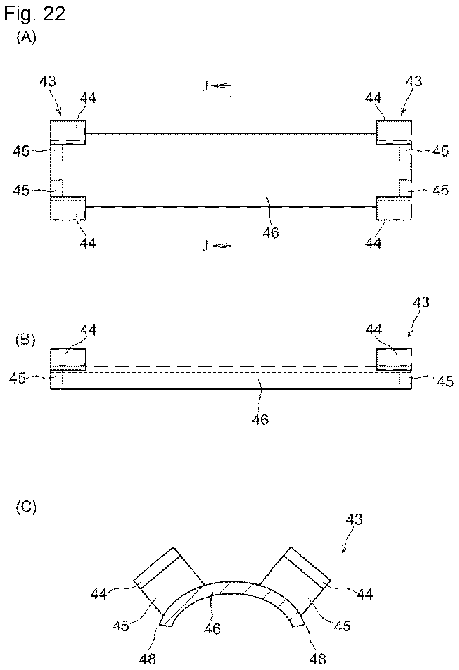

The upper facing portion 44 faces a front surface including the light receiving surface of the photovoltaic power generation sheet 1. The upper facing portion 44 faces an upper side portion of the sealing edge member 10. As illustrated in Fig. 22(C), the upper facing portion 44 is disposed on the upper side with a space from the spacer 46, and a part of the photovoltaic power generation sheet 1 is disposed between the upper facing portion 44 and the spacer 46.

The material of the upper facing portion 44 may be the same as or different from the material of the spacer 46. Since the upper facing portion 44 is directly exposed to wind and rain, it is preferable that the upper facing portion has higher weather resistance than the spacer 46. In this case, for example, a synthetic resin, a composite material, a metal, carbon, ceramic, or the like is preferably used. In addition, in order to maintain the bent state of the photovoltaic power generation sheet 1, a composite reinforced material or metal is more preferable. The material of the reinforced fibers contained in a composite reinforced material is not particularly limited, and examples thereof include glass fibers, carbon fibers, aramid fibers, and metal fibers. The lower limit of the content of the fiber is preferably 5% by mass or more, more preferably 15% by mass or more, and still more preferably 30% by mass or more with respect to the total mass of the upper facing portion 44. When the content of the fibers is in the above range, the strength of the upper facing portion 44 can be set to an appropriate strength. From the viewpoint of enhancing the moldability, the upper limit of the content of the fibers is preferably 80 mass% or less, more preferably 70 mass% or less, and still more preferably 60 mass% or less with respect to the total mass of the upper facing portion 44. The color is preferably close to black. By preventing light transmission, deterioration of the synthetic resin contained in the composite reinforced material can be reduced.

The joint portion 45 faces the end surface of the photovoltaic power generation sheet 1 and connects the upper facing portion 44 and the spacer 46. The upper end portion of the joint portion 45 is connected to the lower surface of the upper facing portion 44, and the lower end portion of the joint portion 45 is connected to the upper surface of the spacer 46. A plurality of joint portions 45 are connected to the plurality of upper facing portions 44 on a one-to-one basis. The material of the joint portion 45 may be the same as or different from the material of the spacer 46 and/or the upper facing portion 44. The spacer 46, the upper facing portion 44, and the joint portion 45 can be integrally formed of the same material, so that damage on not only the back surface but also the side surface of the photovoltaic power generation sheet 1 can be reduced.

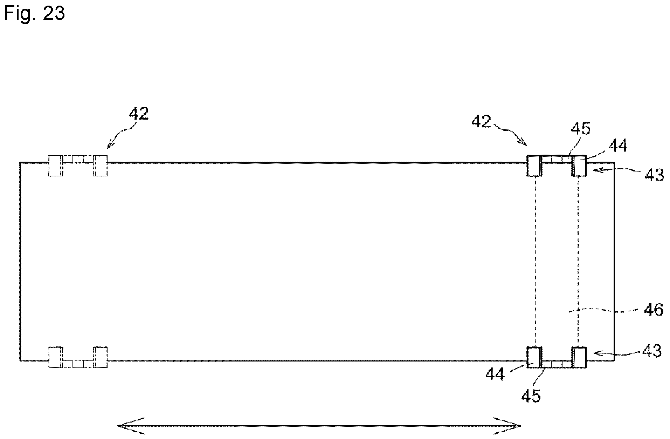

It is preferable that a plurality of upper facing portions 44 of the attachment portion 43 is slidable on the front surface of the photovoltaic power generation sheet 1 in a direction intersecting the direction in which the corner portion 30 of the installation surface 3 extends. As a result, as illustrated in Fig. 23, the spacer 46 is movable in the direction intersecting the direction in which the corner portion 30 of the installation surface 3 extends with respect to the photovoltaic power generation sheet 1 by the attachment portion 43. In Fig. 23, the spacer member 42 moves with respect to the photovoltaic power generation sheet 1, and the photovoltaic power generation sheet 1 may move with respect to the spacer member 42, and the photovoltaic power generation sheet 1 and the spacer member 42 may move relative to each other.

The method of moving the attachment portion 43 is not particularly limited, and for example, a rail portion may be provided in the photovoltaic power generation sheet 1, and the attachment portion 43 may be attached to the rail portion. Examples of the rail include a guide bar, a groove, and a wire. As described above, since the spacer 46 is movably attached to the photovoltaic power generation sheet 1 by the attachment portion 43, it is easy to finely adjust the position of the photovoltaic power generation sheet 1 after the spacer 46 is positioned at the corner portion 30 of the installation surface 3 when the photovoltaic power generation sheet 1 is being installed.

Next, an example of a method of installing the photovoltaic power generation sheet 1 on the installation surface 3 having the corner portions 30 will be described. The spacer 46 is attached to the photovoltaic power generation sheet 1 by the attachment portion 43. Then, as illustrated in Figs. 20 and 21, the photovoltaic power generation sheet 1 is placed on the installation surface 3 across the corner portion 30 while covering the corner portion 30 of the installation surface 3 with the spacer 46. Under this state, the gap between the outer peripheral edge of the photovoltaic power generation sheet 1 and the installation surface 3 is closed using the sealing member such as the bonder, the cover member, and the joint material described above with respect to the installation surface 3. The sealing member may not block the gap between the outer peripheral edge of the photovoltaic power generation sheet 1 and the installation surface 3 in the vicinity of the spacer 46 (in the vicinity of the corner portion 30). That is, the sealing member closes the gap between the outer peripheral edge of the photovoltaic power generation sheet 1 and the installation surface 3 at the 30 other than the corner portion of the installation surface 3. In addition, when the photovoltaic power generation sheet 1 and the installation surface 3 need to be fixed, the photovoltaic power generation sheet 1 and the installation surface 3 are fixed using the bonder or the fixture described above. According to the installation structure 25 illustrated in Figs. 20 and 21, since the spacer 46 is disposed between the corner portion 30 of the installation surface 3 and the photovoltaic power generation sheet 1, damage to the photovoltaic power generation sheet 1 due to the corner portion 30 can be suppressed.

On the corner portion 30 of the installation surface 3, the power generator 7 of the photovoltaic power generation sheet 1 may be positioned, or a portion between adjacent power generators 7 may be positioned. That is, the attachment portion 43 may be positioned at a position corresponding to power generator 7, or may be positioned between adjacent power generators 7. Here, according to the spacer member 42, even when the power generator is positioned at a position overlapping the corner portion 30 in plan view, it is possible to prevent the photovoltaic power generation sheet 1 from being excessively bent.

In the installation structure 25 illustrated in Figs. 20 and 21, one spacer 46 is joint to the pair of attachment portions 43, but the spacer 46 may be joint to each of the pair of attachment portions 43, and the pair of spacers 46 may be disposed between the corner portion 30 of the installation surface 3 and the photovoltaic power generation sheet 1 to suppress the damage to the photovoltaic power generation sheet 1 due to the corner portion 30. As a result, the spacer member 42 can be easily attached to the photovoltaic power generation sheet 1 while obtaining the same effect, and the cost of the spacer member 42 can be reduced. In this case, the thickness of the spacer 46 is preferably set in consideration of the deflection amount of the photovoltaic power generation sheet 1. The pair of spacers 46 may keep the photovoltaic power generation sheet 1 and the corner portion 30 of the installation surface 3 in a non-contact state, or may bring the photovoltaic power generation sheet 1 partially into contact with the corner portion 30 of the installation surface 3.

Further, in the installation structure 25 illustrated in Figs. 20 and 21, one spacer 46 is joint to the pair of attachment portions 43, and one spacer 46 may be joint to one attachment portion 43.

Furthermore, the spacer 46 may be freely deformable by being formed of an elastically deformable material. As a result, the spacer 46 can be appropriately deformed according to the shape and size of the corner portion 30 of the installation surface 3. The flexural modulus of the spacer 46 is preferably larger than the flexural modulus of the photovoltaic power generation sheet 1. Since the spacer 46 receives an external force from the photovoltaic power generation sheet 1 when supporting the photovoltaic power generation sheet 1, when the flexural modulus is small, the spacer 46 can be deformed to a curvature radius close to the curvature radius of the corner portion 30. The flexural strength of the spacer 46 is not particularly limited, and is preferably 1.05 times or more and 5 times or less, more preferably 1.25 times or more and 3 times or less, and more preferably 1.5 times or more and 2 times or less the flexural strength of the photovoltaic power generation sheet 1. The flexural strength of the spacer 3 is preferably 15 MPa or more and 250 MPa or less, more preferably 25 MPa or more and 230 MPa or less, and more preferably 50 MPa or more and 210 MPa or less. In this way, it is possible to suppress deformation of the spacer 46 while reducing damage to the spacer 46 with respect to the photovoltaic power generation sheet 1.

In the installation structure for the present disclosure, instead of the photoelectric conversion layer 132 containing a perovskite compound, the photovoltaic power generation sheet 1 may have a photoelectric conversion layer containing amorphous silicon, or may have a photoelectric conversion layer having a tandem laminated structure containing amorphous silicon and a perovskite compound in a composite manner. As long as the perovskite compound is contained in the photoelectric conversion layer, the dependence of the power generation efficiency of the perovskite compound is relatively low with respect to the incident angle of light, so that higher power generation efficiency can be obtained.

In the installation structure for the above embodiment, the photovoltaic power generation sheet having the photoelectric conversion layer containing the perovskite compound has been described as one aspect of the photovoltaic power generation sheet 1, but in the installation structure for the present disclosure, the photovoltaic power generation sheet 1 can exhibit the same effect as long as the photovoltaic power generation sheet 1 is flexible. In addition, the photovoltaic power generation sheet of the present disclosure may be not only a sheet that can obtain a power generation effect by light, but also a sheet that converts light energy into another energy, for example, a light heating sheet (photovoltaic power-driven thermoelectric conversion device) that converts light energy into thermal energy.

In addition, the present disclosure includes the installation structure for the photovoltaic power generation sheet according to the following items A to F in order to solve the problem that when the entire photovoltaic power generation sheet is fixed to the installation surface with a bonder or the like, or the outer peripheral portion of the photovoltaic power generation sheet is fixed to the installation surface with a bonder or the like over the entire circumference, the power generator may be bent when the photovoltaic power generation sheet 1 is peeled off from the installation surface, and stress is concentrated on the power generator to break the power generator in a case where the photovoltaic power generation sheet needs to be collected.

Item A. An installation structure for a photovoltaic power generation sheet, including:
a photovoltaic power generation sheet including a power generator and being flexible;
an installation surface on which the photovoltaic power generation sheet is installed; and
a fixing member interposed between the photovoltaic power generation sheet and the installation surface to fix the photovoltaic power generation sheet to the installation surface, wherein
the fixing member extends in one direction of the photovoltaic power generation sheet, and fixes the photovoltaic power generation sheet to the installation surface in a plurality of portions avoiding the power generator and spaced apart from each other in another direction orthogonal to the one direction.

Item B. The installation structure according to item A, wherein
the power generator includes a plurality of power generators, and the plurality of the power generator are arranged at intervals in the another direction, and
the fixing member includes a plurality of fixing members and the plurality of fixing members are arranged at intervals in the another direction sandwiching each of the plurality of power generators.

Item C. The installation structure according to item B, wherein
the photovoltaic power generation sheet has a rectangular shape in plan view, and
the fixing member is disposed in such a manner that the fixing member extends along a pair of sides facing each other of the photovoltaic power generation sheet, and is disposed in a portion between power generators adjacent in such a manner that the fixing member extends in parallel with the pair of sides.

Item D. The installation structure according to any one of items A to C, wherein the fixing member is at least one selected from a group consisting of a hook and loop fastener, a magnet, a double-sided tape, and a bonder.

Item E. The installation structure according to any one of items A to D, wherein the photovoltaic power generation sheet has a flexural strength of 50 MPa or more and 200 MPa or less.

Item F. The installation structure according to any one of items A to E, wherein the power generator contains a perovskite compound.

According to the installation structure, there is an advantage that the photovoltaic power generation sheet being flexible can be easily installed on the installation surface such as the surface of the roof, and the photovoltaic power generation sheet can be easily peeled off from the installation surface while the breakage of the power generator is suppressed.

In addition, the present disclosure includes, as a subject, the installation structure for the photovoltaic power generation sheet according to items G to M below in order to solve the problem that when the entire photovoltaic power generation sheet is fixed to the installation surface with a bonder or the like, or the outer peripheral portion of the photovoltaic power generation sheet is fixed to the installation surface over the entire circumference with a bonder or the like, water remains between the photovoltaic power generation sheet and the installation surface when water such as rainwater enters between the photovoltaic power generation sheet and the installation surface, but since the base member of the photovoltaic power generation sheet is formed of a resin material, when water remains between the photovoltaic power generation sheet and the installation surface, steam generated by vaporization of water may pass through the base member or water may penetrate the base member, and water may come into contact with the power generator, leading to deterioration of the photovoltaic power generation sheet.

Item G. An installation structure for a photovoltaic power generation sheet, including:
an installation surface that intersects with a horizontal plane at an angle;
a photovoltaic power generation sheet being flexible; and
a fixing member for fixing the photovoltaic power generation sheet installed on the installation surface to the installation surface, wherein
a portion of an outer peripheral portion of the photovoltaic power generation sheet is fixed to the installation surface by the fixing member, and
the outer peripheral portion includes at least one non-fixed portion that is not fixed to the installation surface at a lower edge portion of the outer peripheral portion.

Item H. The installation structure according to item G, wherein the outer peripheral portion includes the non-fixed portion at a position of a bottom of the lower edge portion.

Item I. The installation structure according to item G or item H, wherein the outer peripheral portion includes the non-fixed portion at a position of a corner where each of left and right side edge portions of the outer peripheral portion meets the lower edge portion.

Item J. The installation structure according to any one of items G to I, wherein the outer peripheral portion includes at least one of the non-fixed portions at an upper edge portion of the outer peripheral portion.

Item K. The installation structure according to any one of items G to J, wherein the fixing member is at least one selected from a group consisting of a hook and loop fastener, a magnet, a double-sided tape, a bonder, a bolt, a screw, and a staple.

Item L. The installation structure according to any one of items G to K, wherein the photovoltaic power generation sheet includes a plurality of power generators containing a perovskite compound.

Item M. The installation structure according to any one of items G to L, wherein the photovoltaic power generation sheet has a flexural strength of 50 MPa or more and 200 MPa or less.

According to the installation structure, there is an advantage that the photovoltaic power generation sheet being flexible can be easily installed on the installation surface, and deterioration of the installed photovoltaic power generation sheet due to water such as rainwater can be suppressed.

In addition, the present disclosure includes, as a subject, the installation structure for the photovoltaic power generation sheet according to the following items N to R in order to solve the problem that there is a possibility that the photovoltaic power generation sheet comes into contact with the top of the corner portion and the photovoltaic power generation sheet is damaged when the photovoltaic power generation sheet is installed across the corner portion such as the ridge of the roof.

Item N. An installation structure for a photovoltaic power generation sheet, including:
an installation surface having at least one corner portion extending in the first direction;
a photovoltaic power generation sheet being flexible and installed on the installation surface across the corner portion;
a spacer disposed between the corner portion and the photovoltaic power generation sheet; and
an attachment portion that attaches the spacer to the photovoltaic power generation sheet.

Item O. The installation structure according to item N, wherein the spacer extends from one end portion to the other end portion of a main body of the photovoltaic power generation sheet in the first direction.

Item P. The installation structure according to item N or O, wherein the spacer is attached to the photovoltaic power generation sheet in such a manner that the spacer is movable in a direction intersecting the first direction by the attachment portion.

Item Q. The installation structure according to item P, wherein
the attachment portion includes:
an upper facing portion facing a surface including a light receiving surface of the power generation sheet main body; and
a joint portion facing an end surface of the power generation sheet main body and connecting the upper facing portion and the spacer.

Item R. The installation structure according to any one of items N to Q, wherein the spacer is formed in a curved shape in such a manner of covering the corner portion in a cross section orthogonal to the first direction.

According to the installation structure, there is an advantage that, in a case where the photovoltaic power generation sheet is installed across the corner portion on the installation surface having the corner portion, the photovoltaic power generation sheet is less likely to be damaged by the corner portion.

In addition, the present disclosure includes a spacer member according to the following item S as a subject.

Item S. A spacer member that is used when a photovoltaic power generation sheet having a power generator that generates power by sunlight and being flexible is installed on an installation surface having a corner portion extending in one direction across the corner portion, the spacer member including:
a spacer disposed between the corner portion and the photovoltaic power generation sheet; and
an attachment portion that attaches the spacer to the photovoltaic power generation sheet.

### Description of Reference Numerals

1 Photovoltaic power generation sheet
2, 20-25 Installation structure for photovoltaic power generation sheet
3 Installation surface
4 Bonder
15 Cover member
18 Covered portion of cover member

## Claims

1. An installation structure for a photovoltaic power generation sheet, comprising:
an installation surface;
a photovoltaic power generation sheet installed above the installation surface; and
a sealing member that closes a gap between an outer peripheral edge of the photovoltaic power generation sheet and the installation surface.

2. The installation structure according to claim 1, wherein the sealing member is formed of a bonder provided between at least an outer peripheral portion of the photovoltaic power generation sheet and the installation surface to bond the outer peripheral portion to the installation surface.

3. The installation structure according to claim 2, wherein the bonder has a loss factor of 0.01 or more and 0.3 or less.

4. The installation structure according to claim 3, wherein the bonder has a thickness of 3 mm or more.

5. The installation structure for a photovoltaic power generation sheet according to claim 2, wherein the bonder has a modulus of transverse elasticity of 0.1 MPa or more and 100 MPa or less.

6. The installation structure according to claim 2, wherein the bonder has a viscosity of 800cP or more.

7. The installation structure according to claim 2, wherein the bonder includes at least one or more resin compositions selected from a vinyl acetate resin, an ethylene vinyl acetate resin, an epoxy resin, a cyanoacrylate resin, an acrylic resin, a chloroprene rubber, styrene, a butadiene rubber, a polyurethane resin, a silicone resin, and a modified silicone resin.

8. The installation structure according to claim 2, wherein the bonder is provided between the photovoltaic power generation sheet entire and the installation surface.

9. The installation structure according to claim 2, further comprising:
a cover member that covers the bonder between an outer peripheral edge of the photovoltaic power generation sheet and the installation surface, wherein
the cover member has an ultraviolet ray blocking property.

10. The installation structure according to claim 9, wherein the cover member includes a covered portion that covers a portion having a predetermined width from an outer peripheral edge on a front surface of the photovoltaic power generation sheet.

11. The installation structure according to claim 1, wherein the sealing member includes a cover member that covers a gap between an outer peripheral edge of the photovoltaic power generation sheet and the installation surface.

12. The installation structure according to claim 1, wherein the sealing member is formed of a joint material filled in a gap between at least an outer peripheral portion of the photovoltaic power generation sheet and the installation surface.

13. The installation structure according to any one of claims 1 to 12, wherein the photovoltaic power generation sheet has flexibility.
